# EUROPEAN PATENT APPLICATION

(11) **EP 4 593 069 A2**
(43) Date of publication of application: **30.07.2025**
(21) Application number: 25151992.2
(22) Date of filing: 15.01.2025
(51) Int. Cl.: H01L 21/67

(54) **SUBSTRATE PROCESSING APPARATUS AND SUBSTRATE PROCESSING METHOD**

(30) Priority: 25.01.2024 JP 2024009545
(71) Applicant: SCREEN Holdings Co., Ltd., Kyoto-shi, Kyoto 602-8585 (JP)
(72) Inventor: KAMMURI, Takuya, Kyoto, 602-8585 (JP); NAGAMI, Shuzo, Kyoto, 602-8585 (JP); OKAMOTO, Koichi, Kyoto, 602-8585 (JP); SAWASHIMA, Jun, Kyoto, 602-8585 (JP)
(74) Representative: Kilian Kilian & Partner mbB

(57) **Abstract**

A substrate processing apparatus (100) includes a chamber (11) to accommodate a substrate (W) having a front surface (Wa) on which a device is provided and a rear surface (Wb) positioned on an opposite side to the front surface (Wa), a substrate holding portion (20) to hold the substrate (W) in the chamber (11), a chemical liquid supplying portion (30) to supply a chemical liquid to the front surface (Wa) of the substrate (W) held by the substrate holding portion (20), a rinse liquid supplying portion (40) to supply a rinse liquid to the front surface (Wa) of the substrate (W) held by the substrate holding portion (20), a recovered-liquid storage tank (210) to store a recovered liquid obtained by recovering a liquid, and a rear surface processing liquid supplying portion (50) to supply the recovered liquid stored in the recovered-liquid storage tank (210) to the rear surface (Wb) of the substrate (W).

## Description

### CROSS REFERENCE TO RELATED APPLICATIONS

This application claims the benefit of priority to Japanese Patent Application No. 2024-009545 filed on January 25, 2024 and the entire contents of this application are hereby incorporated herein by reference.

### BACKGROUND OF THE INVENTION

### 1. Field of the Invention

The present invention relates to a substrate processing apparatus and a substrate processing method.

### 2. Description of the Related Art

Substrate processing apparatuses that process substrates have been known. Such a substrate processing apparatus is suitably used for processing a semiconductor substrate. A substrate processing apparatus processes substrates using processing liquids.

Typically, a substrate processing apparatus processes a substrate with a chemical liquid, and then supplies a rinse liquid to the substrate to clean the substrate processed with the chemical liquid. There is a case in which, in a substrate processing apparatus, a chemical liquid and a rinse liquid are supplied not only to a front surface of a substrate but also to a rear surface of the substrate (see Japanese Patent Application Publication No. 2019-125634). In a substrate processing apparatus disclosed in Japanese Patent Application Publication No. 2019-125634, a chemical liquid and a rinse liquid are supplied to a front surface and a rear surface of a substrate and then the substrate is dried, and then infrared rays emitted from a processing liquid adhering to the rear surface of the substrate are transmitted through the substrate and received by a light receiving portion of a detection portion, thereby detecting a liquid residue on the rear surface of the substrate. At this time, the processing liquid scattered from the substrate is trapped in a recovery cup, and the processing liquid trapped in the recovery cup is discharged to the outside of a processing unit from a drain port at a bottom portion of the recovery cup. In the substrate processing apparatus disclosed in Japanese Patent Application Publication No. 2019-125634, in a case where a liquid residue adheres on the rear surface of the substrate, the liquid residue on the rear surface of the substrate is eliminated by performing restorative rinse processing.

### SUMMARY OF THE INVENTION

In recent years, reduction of resources required for substrate processing has been studied for the purpose of reducing the environmental load. However, in the substrate processing apparatus disclosed in Japanese Patent Application Publication No. 2019-125634, in a case where a substrate is processed, there is a possibility that a use amount of a new processing liquid will increase.

A preferred embodiment of the present invention provides a substrate processing apparatus and a substrate processing method capable of reducing a use amount of a new processing liquid.

A substrate processing apparatus according to a preferred embodiment of the present invention includes a chamber to accommodate a substrate having a front surface on which a device is provided and a rear surface positioned on an opposite side to the front surface, a substrate holding portion to hold the substrate in the chamber, a chemical liquid supplying portion to supply a chemical liquid to the front surface of the substrate held by the substrate holding portion, and a rinse liquid supplying portion to supply a rinse liquid to the front surface of the substrate held by the substrate holding portion. The substrate processing apparatus preferably includes a recovered-liquid storage tank to store a recovered liquid obtained by recovering a liquid, and a rear surface processing liquid supplying portion to supply the recovered liquid stored in the recovered-liquid storage tank to the rear surface of the substrate.

In one preferred embodiment, the substrate processing apparatus further includes a controlling portion to determine whether or not to recover the liquid into the recovered-liquid storage tank.

In one preferred embodiment, the substrate processing apparatus further includes a storage tank to store a liquid, a heater to heat the liquid flowing from the storage tank, and a temperature measuring portion to measure a temperature of the liquid having heated by the heater. The controlling portion is to determine whether or not to recover the liquid heated by the heater into the recovered-liquid storage tank based on the temperature measured by the temperature measuring portion.

In one preferred embodiment, the substrate processing apparatus further includes an ozone gas generator to generate an ozone gas, an ozone gas dissolving tank to dissolve the ozone gas generated in the ozone gas generator into a liquid to generate an ozone liquid, and a concentration measuring portion to measure an ozone concentration of the ozone liquid generated in the ozone gas dissolving tank. The controlling portion is to determine whether or not to recover the ozone liquid generated in the ozone gas dissolving tank into the recovered-liquid storage tank based on the ozone concentration measured by the concentration measuring portion.

In one preferred embodiment, the chemical liquid supplying portion includes a chemical liquid storage tank to store the chemical liquid, and the recovered-liquid storage tank is to store, as the recovered liquid, at least a part of a cleaning liquid which has cleaned the chemical liquid storage tank.

In one preferred embodiment, the substrate processing apparatus further includes a cup to trap a processing liquid scattering from the substrate held by the substrate holding portion, a drain piping that connects the cup and the recovered-liquid storage tank, and a chamber cleaning piping which is disposed in the chamber and through which a cleaning liquid for cleaning an inside of the chamber is to be discharged. The recovered-liquid storage tank is to store, as the recovered liquid, at least a part of the cleaning liquid discharged from the chamber cleaning piping.

In one preferred embodiment, the rinse liquid supplying portion includes a rinse liquid piping in which the rinse liquid is to flow, and a valve that is provided in the rinse liquid piping and is to adjust a flow rate of the rinse liquid flowing in the rinse liquid piping. The substrate processing apparatus further includes a branch piping which is connected to the rinse liquid piping at a more upstream position than the valve on the rinse liquid piping and in which the rinse liquid is to flow even in a case where the valve is closed. The recovered-liquid storage tank is to store, as the recovered liquid, the rinse liquid which has flowed through the branch piping.

A substrate processing method according to a preferred embodiment of the present invention includes a step of supplying a chemical liquid to a front surface of a substrate having the front surface on which a device is provided and a rear surface positioned on an opposite side to the front surface, and a step of supplying a rinse liquid to the front surface of the substrate after the chemical liquid is supplied to the front surface of the substrate. Preferably, the substrate processing method includes a step of supplying a recovered liquid to the rear surface of the substrate from a recovered-liquid storage tank that is to store the recovered liquid obtained by recovering a liquid. The substrate processing method may further include one or arbitrary combination(s) of various features described with respect to the substrate processing apparatus.

The above and yet other objects, features, and effects of the present invention will become more apparent from the following description of the preferred embodiments made with reference to the attached drawings.

### BRIEF DESCRIPTION OF THE DRAWINGS

FIG. 1 is a schematic plan view of a substrate processing apparatus according to a preferred embodiment.
FIG. 2 is a schematic diagram of the substrate processing apparatus according to the preferred embodiment.
FIG. 3 is a block diagram of the substrate processing apparatus according to the preferred embodiment.
FIG. 4 is a flowchart of a substrate processing method according to the preferred embodiment.
FIGS. 5A to 5C are schematic diagrams illustrating a flow of the substrate processing apparatus according to the preferred embodiment.
FIG. 6 is a schematic plan view of the substrate processing apparatus according to the preferred embodiment.
FIG. 7 is a schematic diagram of the substrate processing apparatus according to the preferred embodiment.
FIG. 8 is a flowchart of the substrate processing method according to the present embodiment.
FIG. 9 is a schematic plan view of the substrate processing apparatus according to the preferred embodiment.
FIG. 10 is a schematic diagram of the substrate processing apparatus according to the preferred embodiment.
FIG. 11 is a flowchart of the substrate processing method according to the preferred embodiment.
FIG. 12 is a schematic diagram of the substrate processing apparatus according to the preferred embodiment.
FIG. 13 is a schematic diagram of the substrate processing apparatus according to the preferred embodiment.
FIG. 14 is a flowchart of the substrate processing method according to the preferred embodiment.
FIG. 15 is a schematic plan view of the substrate processing apparatus according to the preferred embodiment.
FIG. 16 is a schematic diagram of the substrate processing apparatus according to the preferred embodiment.
FIG. 17 is a flowchart of the substrate processing method according to the preferred embodiment.
FIGS. 18A to 18D are schematic diagrams illustrating a flow of the substrate processing apparatus according to the preferred embodiment.
FIG. 19 is a schematic diagram of the substrate processing apparatus according to the preferred embodiment.
FIGS. 20A and 20B are schematic diagrams illustrating a flow of the substrate processing apparatus according to the preferred embodiment.
FIG. 21 is a schematic diagram of the substrate processing apparatus according to the preferred embodiment.
FIGS. 22A and 22B are schematic diagrams illustrating a flow of the substrate processing apparatus according to the preferred embodiment.
FIG. 23 is a schematic diagram of the substrate processing apparatus according to the preferred embodiment.
FIGS. 24A to 24C are schematic diagrams illustrating a flow of the substrate processing apparatus according to the preferred embodiment.
FIGS. 25A and 25B are schematic diagrams illustrating a flow of the substrate processing apparatus according to the preferred embodiment.
FIG. 26 is a schematic diagram of the substrate processing apparatus according to the preferred embodiment.
FIGS. 27A and 27B are schematic diagrams illustrating a flow of the substrate processing apparatus according to the preferred embodiment.
FIGS. 28A and 28B are schematic diagrams illustrating a flow of the substrate processing apparatus according to the preferred embodiment.
FIGS. 29A and 29B are schematic diagrams illustrating a flow of the substrate processing apparatus according to the preferred embodiment.
FIG. 30 is a schematic diagram illustrating a flow of the substrate processing apparatus according to the preferred embodiment.
FIG. 31 is a schematic diagram of the substrate processing apparatus according to the preferred embodiment.
FIGS. 32A to 32C are schematic diagrams illustrating a flow of the substrate processing apparatus according to the preferred embodiment.
FIGS. 33A to 33C are schematic diagrams illustrating a flow of the substrate processing apparatus according to the preferred embodiment.
FIG. 34 is a schematic diagram illustrating a flow of the substrate processing apparatus according to the preferred embodiment.

### DETAILED DESCRIPTION OF THE PREFERRED EMBODIMENTS

Hereinafter, preferred embodiments of a substrate processing apparatus and a substrate processing method according to the present invention will be described with reference to the drawings. It is noted that, in the drawings, the same reference signs are assigned to the same or corresponding portions, and description shall not be repeated. It is noted that, in the present specification, an X-axis, a Y-axis, and a Z-axis orthogonal to each other may be referred to in order to facilitate understanding of the invention. Typically, the X-axis and the Y-axis are parallel to a horizontal direction, and the Z-axis is parallel to a vertical direction.

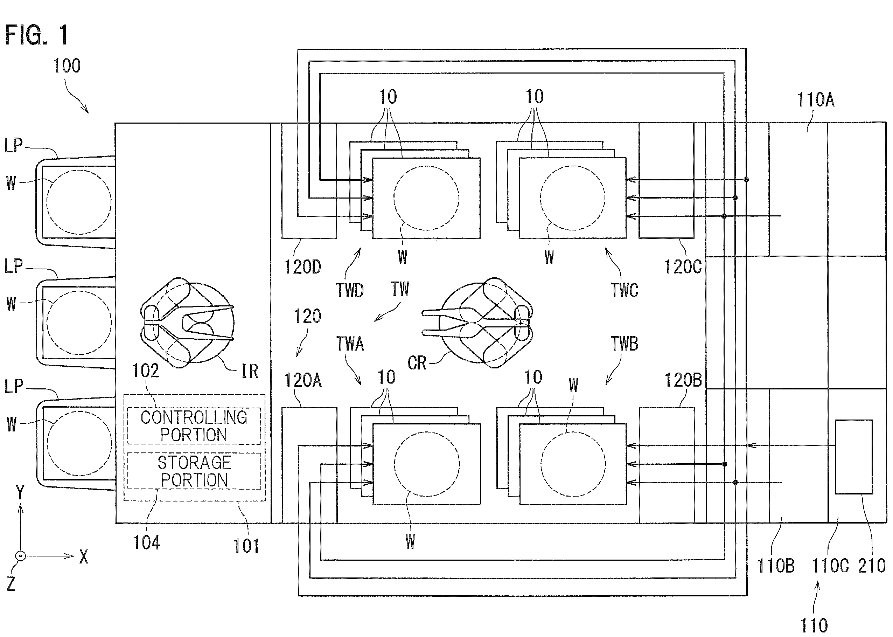

First, a preferred embodiment of a substrate processing apparatus 100 according to a present invention will be described with reference to FIG. 1. FIG. 1 is a schematic plan view of the substrate processing apparatus 100 according to the present preferred embodiment.

The substrate processing apparatus 100 processes a substrate W. The substrate processing apparatus 100 processes the substrate W to perform, on the substrate W, at least one process of etching, surface processing, characteristics imparting, processing film forming, removing at least a part of a film, and cleaning.

The substrate W is used as a semiconductor substrate. The substrate W includes a semiconductor wafer. For example, the substrate W has a substantially disk shape. Here, the substrate processing apparatus 100 processes the substrates W one by one.

As illustrated in FIG. 1, the substrate processing apparatus 100 includes a plurality of substrate processing units 10, a processing liquid cabinet 110, a processing liquid box 120, a plurality of load ports LP, an indexer robot IR, a center robot CR, and a controller 101. The controller 101 controls the load port LP, the indexer robot IR, and the center robot CR. The controller 101 may be configured or programmed to control individual components in the substrate processing unit 10, the processing liquid cabinet 110, and the processing liquid box 120. The controller 101 includes a controlling portion 102 and a storage portion 104.

Each of the load ports LP stacks and accommodates a plurality of substrates W. The indexer robot IR transports the substrates W between the load port LP and the center robot CR. The center robot CR transports the substrates W between the indexer robot IR and the substrate processing unit 10. Each of the substrate processing units 10 discharges a processing liquid onto the substrate W to process the substrate W. The processing liquid contains a chemical liquid, a rinse liquid, a cleaning liquid, a removing liquid, and/or a water repellent. The processing liquid cabinet 110 accommodates the processing liquid. It is noted that, the processing liquid cabinet 110 may accommodate a gas.

Specifically, the plurality of substrate processing units 10 form a plurality of towers TW (four towers TW in FIG. 1) disposed to surround the center robot CR in plan view. Each tower TW includes a plurality of substrate processing units 10 (three substrate processing units 10 in FIG. 1) stacked vertically. The processing liquid boxes 120 correspond to a plurality of towers TW, respectively. A liquid in the processing liquid cabinet 110 is supplied to all of the substrate processing units 10 included in the tower TW corresponding to the processing liquid box 120 through any one of the processing liquid boxes 120. Also, the gas in the processing liquid cabinet 110 is supplied to all of the substrate processing units 10 included in the tower TW corresponding to the processing liquid box 120 through any one of the processing liquid boxes 120.

In the substrate processing apparatus 100, a boundary wall or partition wall is disposed between a region where the center robot CR and the substrate processing units 10 are installed and a region where the processing liquid cabinet 110 is installed.

Typically, the processing liquid cabinet 110 has a storage tank (tank) to prepare the processing liquid. The processing liquid cabinet 110 may have a storage tank for one type of processing liquid or may have a storage tank for a plurality of types of processing liquids. Also, the processing liquid cabinet 110 has a pump to circulate the processing liquid, a valve, a heater, and/or a filter.

The processing liquid cabinet 110 includes a chemical liquid cabinet 110A and a rinse liquid cabinet 110B. For example, the chemical liquid cabinet 110A and the rinse liquid cabinet 110B are disposed apart from each other. It is noted that, the chemical liquid cabinet 110A and the rinse liquid cabinet 110B may be disposed adjacent to each other.

For example, the chemical liquid cabinet 110A supplies the chemical liquid to the processing liquid box 120. Also, the rinse liquid cabinet 110B supplies the rinse liquid to the processing liquid box 120. The processing liquid box 120 supplies the chemical liquid and the rinse liquid to the substrate processing unit 10.

Here, the processing liquid cabinet 110 further includes a recovered-liquid cabinet 110C. The recovered-liquid cabinet 110C stores the recovered liquid obtained by recovering a liquid. For example, the recovered-liquid cabinet 110C recovers, as the recovered liquid, a liquid once used. Also, the recovered-liquid cabinet 110C supplies the recovered liquid obtained by recovering a liquid to the processing liquid box 120.

The recovered-liquid cabinet 110C includes a recovered-liquid storage tank (tank) 210 to store, as the recovered liquid, a liquid once used. The recovered liquid stored in the recovered-liquid storage tank 210 is supplied to the processing liquid box 120.

The processing liquid cabinet 110 may include a recovered-liquid storage tank 210 to store one type of recovered liquid, and may include a recovered-liquid storage tank 210 to store a plurality of types of recovered liquids. Also, the processing liquid cabinet 110 has a pump to circulate the recovered liquid, a valve, a heater, and/or a filter.

The controller 101 controls various operations of the substrate processing apparatus 100. The controller 101 causes the substrate processing unit 10 to process the substrate W.

The controller 101 includes a controlling portion 102 and a storage portion 104. The controlling portion 102 includes a processor. The controlling portion 102 includes, for example, a central processing unit (CPU). Alternatively, the controlling portion 102 may include a general-purpose calculator.

The storage portion 104 is a storage that stores data and a computer program. The data includes recipe data. The recipe data includes information indicating a plurality of recipes. Each of the plurality of recipes defines processing details and a processing procedure of the substrate W.

The storage portion 104 includes a main storage and an auxiliary storage. The main storage is, for example, a semiconductor memory. The auxiliary storage is, for example, a semiconductor memory and/or a hard disk drive. The storage portion 104 may include a removable medium. The controlling portion 102 executes a computer program stored in the storage portion 104 to execute a substrate processing operation.

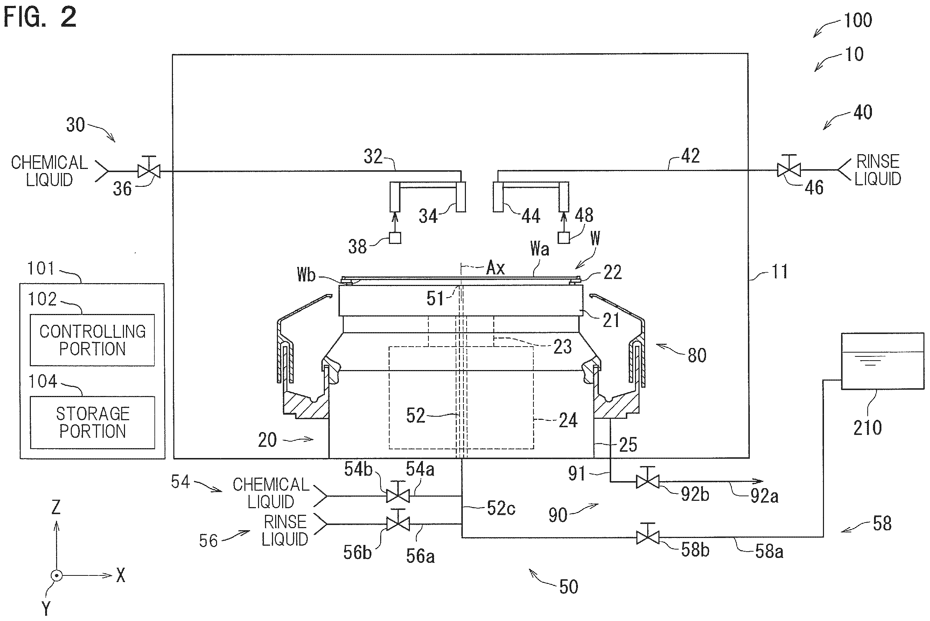

Next, the substrate processing unit 10 in the substrate processing apparatus 100 according to the present preferred embodiment will be described with reference to FIG. 2. FIG. 2 is a schematic diagram of the substrate processing apparatus 100.

The substrate processing apparatus 100 includes the substrate processing unit 10, a chamber 11, a substrate holding portion 20, a chemical liquid supplying portion 30, a rinse liquid supplying portion 40, a rear surface processing liquid supplying portion 50, a cup 80, a drain mechanism 90, and the recovered-liquid storage tank 210.

The chamber 11 has a substantially box shape with an internal space. The chamber 11 accommodates the substrate W. Here, the substrate processing apparatus 100 is a single substrate processing type that processes the substrates W one by one, and the chamber 11 accommodates the substrates W one by one. The substrate W is accommodated in the chamber 11 and processed in the chamber 11. The chamber 11 accommodates at least some of the substrate holding portion 20, the chemical liquid supplying portion 30, the rinse liquid supplying portion 40, the rear surface processing liquid supplying portion 50, and the cup 80.

The substrate holding portion 20 is a substrate holder that holds the substrate W, and may typically be a spin chuck. The substrate W has a front surface Wa and a rear surface Wb. The front surface Wa and the rear surface Wb of the substrate W are principal surfaces of the substrate W, respectively. A device is provided on the front surface Wa of the substrate W. The front surface Wa of the substrate W is a surface on which a device in which an electronic circuit is formed is provided, and the rear surface Wb of the substrate W is a surface on which such a device is not provided. For example, a laminated structure in which a recess is formed is provided on the front surface Wa of the substrate W.

The substrate holding portion 20 horizontally holds the substrate W. The substrate holding portion 20 rotates the substrate W in the state of holding the substrate W. It is noted that, here, the front surface Wa of the substrate W faces vertically upward, and the rear surface Wb of the substrate W faces vertically downward. However, the front surface Wa of the substrate W may face vertically downward, and the rear surface Wb of the substrate W may face vertically upward. As described above, the substrate holding portion 20 horizontally holds the substrate W such that one of the front surface Wa and the rear surface Wb of the substrate W faces upward and the other faces downward.

For example, the substrate holding portion 20 may be a mechanical type or a pinching type that pinches an end portion of the substrate W. The substrate holding portion 20 may have an arbitrary mechanism that holds the substrate W from the rear surface Wb. For example, the substrate holding portion 20 may be a vacuum type. In this case, the substrate holding portion 20 horizontally holds the substrate W by suctioning, on an upper surface, a central portion of the rear surface Wb of the substrate W which is the non-device-forming surface. Alternatively, the substrate holding portion 20 may be a combination of the pinching type and the vacuum type in which a plurality of chuck pins are brought into contact with a circumferential end surface of the substrate W.

For example, the substrate holding portion 20 includes a spin base 21, a chuck member 22, a shaft 23, an electric motor 24, a housing 25, and a nozzle 51. The chuck member 22 is provided on the spin base 21. The chuck member 22 chucks the substrate W. Typically, the spin base 21 includes a plurality of chuck members 22.

The shaft 23 is a hollow shaft. The shaft 23 extends in the vertical direction along a rotation axis Ax. A spin base 21 is coupled to an upper end of the shaft 23. The substrate W is placed above the spin base 21.

The spin base 21 has a disk shape and horizontally supports the substrate W. The shaft 23 extends downward from a central portion of the spin base 21. The electric motor 24 applies a rotation force to the shaft 23. The electric motor 24 rotates the shaft 23 in a rotation direction, thereby rotating the substrate W and the spin base 21 around the rotation axis Ax. The housing 25 surrounds the shaft 23 and the electric motor 24.

The chemical liquid supplying portion 30 supplies a chemical liquid to the substrate W. Typically, the chemical liquid supplying portion 30 supplies the chemical liquid to the front surface Wa of the substrate W. At least a part of the chemical liquid supplying portion 30 is accommodated in the chamber 11.

The chemical liquid contains hydrofluoric acid. For example, hydrofluoric acid may be heated to 40°C or higher and 70°C or lower, or may be heated to 50°C or higher and 60°C or lower. However, hydrofluoric acid does not have to be heated. Also, the chemical liquid may contain phosphoric acid.

The chemical liquid may contain hydrogen peroxide water. Also, the chemical liquid may contain SC1 (a mixture liquid of ammonia and hydrogen peroxide water), SC2 (a mixture liquid of hydrochloric acid and hydrogen peroxide water), or aqua regia (a mixture of concentrated hydrochloric acid and concentrated nitric acid). Also, the chemical liquid may be diluted with a diluent.

The chemical liquid supplying portion 30 includes a piping 32, a nozzle 34, and a valve 36. The nozzle 34 is connected to the piping 32. The chemical liquid is supplied from a supply source to the piping 32. The valve 36 opens and closes a flow channel in the piping 32. The nozzle 34 discharges the chemical liquid onto the front surface Wa of the substrate W.

The valve 36 adjusts an opening degree of the piping 32 to adjust a flow rate of the chemical liquid flowing in the piping 32. Specifically, the valve 36 includes a valve body (not shown) with a valve seat provided in an interior, a valve element which opens/closes the valve seat, and an actuator (not shown) which moves the valve element between an open position and a closed position.

The nozzle 34 may be configured to be movable with respect to the substrate W. The chemical liquid supplying portion 30 may further include a nozzle moving portion 38. The nozzle moving portion 38 may elevate and lower the nozzle 34, and may horizontally rotate the nozzle 34 around a rotation axis. The nozzle moving portion 38 elevates and lowers the nozzle 34. For example, the nozzle moving portion 38 includes a ball screw mechanism and an electric motor that applies a driving force to the ball screw mechanism. Also, the nozzle moving portion 38 horizontally rotates the nozzle 34. For example, the nozzle moving portion 38 includes an electric motor.

It is noted that, the chemical liquid supplying portion 30 may include the chemical liquid cabinet 110A and the processing liquid box 120 illustrated in FIG. 1.

The rinse liquid supplying portion 40 supplies the rinse liquid to the substrate W. Typically, the rinse liquid is used to clean the substrate W. The rinse liquid supplying portion 40 supplies the rinse liquid to the front surface Wa of the substrate W. At least a part of the rinse liquid supplying portion 40 is accommodated in the chamber 11.

For example, the rinse liquid is used to clean the substrate W processed with the chemical liquid. In one example, the rinse liquid may contain any one of, for example, deionized water (DIW), carbonated water, electrolyzed ion water, ozone water, ammonia water, hydrochloric acid solution with a diluted concentration (for example, about 10 ppm to 100 ppm), and reduced water (hydrogen water).

The rinse liquid supplying portion 40 includes a piping 42, a nozzle 44, and a valve 46. The nozzle 44 is connected to the piping 42. The rinse liquid is supplied from a supply source to the piping 42. The valve 46 opens and closes a flow channel in the piping 42. The nozzle 44 discharges the rinse liquid onto the front surface Wa of the substrate W.

The valve 46 adjusts an opening degree of the piping 42 to adjust a flow rate of the rinse liquid flowing in the piping 42. Specifically, the valve 46 may have a configuration similar to that of the valve 36.

The nozzle 44 may be configured to be movable with respect to the substrate W. The rinse liquid supplying portion 40 may further include a nozzle moving portion 48. The nozzle moving portion 48 may have the same configuration as the nozzle moving portion 38.

It is noted that, the rinse liquid supplying portion 40 may include the rinse liquid cabinet 110B and the processing liquid box 120 illustrated in FIG. 1.

The rear surface processing liquid supplying portion 50 supplies a processing liquid to the rear surface Wb of the substrate W. At least a part of the rear surface processing liquid supplying portion 50 is accommodated in the chamber 11.

For example, the rear surface processing liquid supplying portion 50 supplies the chemical liquid to the rear surface Wb of the substrate W. Typically, while the chemical liquid supplying portion 30 supplies the chemical liquid to the front surface Wa of the substrate W, the rear surface processing liquid supplying portion 50 supplies the chemical liquid to the rear surface Wb of the substrate W. In one example, the rear surface processing liquid supplying portion 50 supplies, to the rear surface Wb of the substrate W, the same type of chemical liquid as the chemical liquid supplied by the chemical liquid supplying portion 30.

Alternatively, the rear surface processing liquid supplying portion 50 supplies the rinse liquid to the substrate W. Typically, while the rinse liquid supplying portion 40 supplies the rinse liquid to the front surface Wa of the substrate W, the rear surface processing liquid supplying portion 50 supplies the rinse liquid to the rear surface Wb of the substrate W. In one example, the rear surface processing liquid supplying portion 50 supplies, to the rear surface Wb of the substrate W, the same type of rinse liquid as the rinse liquid supplied by the rinse liquid supplying portion 40.

It is noted that, the rear surface processing liquid supplying portion 50 may supply a chemical liquid (diluted chemical liquid) diluted with a diluent to the rear surface Wb of the substrate W. Typically, while the chemical liquid supplying portion 30 supplies the diluted chemical liquid to the front surface Wa of the substrate W, the rear surface processing liquid supplying portion 50 may supply the diluted chemical liquid to the rear surface Wb of the substrate W.

In the present preferred embodiment, the rear surface processing liquid supplying portion 50 supplies the recovered liquid to the rear surface Wb of the substrate W. Typically, the recovered liquid is a liquid obtained by recovering a processing liquid that has been used once. In one example, the recovered liquid is a liquid obtained by recovering a rinse liquid that has been used once. For example, the rinse liquid used for rinse processing of the substrate W is recovered and used as the recovered liquid.

Typically, the substrate W is used for a microfabricated semiconductor device. Therefore, the chemical liquid or the rinse liquid supplied from the supply source is an unused new liquid, and the chemical liquid or the rinse liquid supplied from the supply source has a low impurity concentration. On the other hand, the recovered liquid may have a slightly higher impurity concentration as compared to the chemical liquid or the rinse liquid supplied from the supply source. Consequently, it is possible to prevent particles produced by cleaning the rear surface Wb of the substrate W or processing the front surface Wa of the substrate W with a chemical liquid, etc., from adhering to the rear surface Wb of the substrate W. However, it is preferable that the impurity concentration of the recovered liquid also be low.

For example, while the rinse liquid supplying portion 40 supplies the rinse liquid to the front surface Wa of the substrate W, the rear surface processing liquid supplying portion 50 may supply the recovered liquid to the rear surface Wb of the substrate W. Alternatively, while the chemical liquid supplying portion 30 supplies the chemical liquid to the front surface Wa of the substrate W, the rear surface processing liquid supplying portion 50 may supply the recovered liquid to the rear surface Wb of the substrate W. Alternatively, while the chemical liquid supplying portion 30 supplies the diluted chemical liquid diluted with the diluent to the front surface Wa of the substrate W, the rear surface processing liquid supplying portion 50 may supply the chemical liquid diluted with the recovered liquid to the rear surface Wb of the substrate W.

The rear surface processing liquid supplying portion 50 includes a nozzle 51, a piping 52, a piping 52c, a chemical liquid supplying portion 54, a rinse liquid supplying portion 56, and a recovered-liquid supplying portion 58. The piping 52 is positioned in the chamber 11. The piping 52 penetrates the center of the shaft 23 in the vertical direction. The nozzle 51 is disposed at an end portion of the piping 52. The nozzle 51 is positioned opposing the center of the rear surface Wb of the substrate W. The piping 52 is connected to the piping 52c outside the chamber 11. The processing liquid supplied to the rear surface Wb of the substrate W flows into the piping 52c and the piping 52. The processing liquid which has flowed through the piping 52c and the piping 52 is discharged from the nozzle 51 to the rear surface Wb of the substrate W.

The chemical liquid supplying portion 54 supplies the chemical liquid to the rear surface Wb of the substrate W. Specifically, the chemical liquid supplying portion 54 supplies the chemical liquid to the rear surface Wb of the substrate W through the piping 52c and the piping 52.

The chemical liquid supplying portion 54 includes a piping 54a and a valve 54b. The chemical liquid is supplied from the supply source to the piping 54a. The valve 54b opens and closes a flow channel in the piping 54a. The valve 54b adjusts an opening degree of the piping 54a to adjust a flow rate of the chemical liquid flowing in the piping 54a. Specifically, the valve 54b includes a valve body (not shown) with a valve seat provided in an interior, a valve element which opens/closes the valve seat, and an actuator (not shown) which moves the valve element between an open position and a closed position.

The chemical liquid which has flowed through the piping 52c and the piping 52 from the piping 54a is discharged from the nozzle 51 to the rear surface Wb of the substrate W.

The rinse liquid supplying portion 56 supplies the rinse liquid to the rear surface Wb of the substrate W. Specifically, the rinse liquid supplying portion 56 supplies the rinse liquid to the rear surface Wb of the substrate W through the piping 52c and the piping 52.

The rinse liquid supplying portion 56 includes a piping 56a and a valve 56b. The rinse liquid is supplied from the supply source to the piping 56a. The valve 56b opens and closes a flow channel in the piping 56a. The valve 56b adjusts an opening degree of the piping 56a to adjust a flow rate of the rinse liquid flowing in the piping 56a. The valve 56b may have a configuration similar to that of the valve 54b.

The rinse liquid which has flowed through the piping 52c and the piping 52 from the piping 56a is discharged from the nozzle 51 to the rear surface Wb of the substrate W.

The recovered-liquid supplying portion 58 supplies the recovered liquid to the rear surface Wb of the substrate W. Specifically, the recovered-liquid supplying portion 58 supplies the recovered liquid to the rear surface Wb of the substrate W through the piping 52c and the piping 52.

The recovered-liquid supplying portion 58 includes a piping 58a and a valve 58b. The recovered liquid is supplied to the piping 58a from the recovered-liquid storage tank 210 serving as a supply source. The valve 58b opens and closes a flow channel in the piping 58a. The valve 58b adjusts an opening degree of the piping 58a to adjust a flow rate of the recovered liquid flowing in the piping 58a. The valve 58b may have a configuration similar to that of the valve 54b.

The recovered liquid which has flowed through the piping 52c and the piping 52 from the piping 58a is discharged from the nozzle 51 to the rear surface Wb of the substrate W.

The cup 80 is elevated and lowered along the vertical direction. The cup 80 is elevated to an upper position that is positioned laterally to the substrate W. Also, the cup 80 is lowered to a lower position that is positioned obliquely below the substrate W. In FIG. 2, the cup 80 is positioned at the lower position. In a case where any one of the chemical liquid, the rinse liquid, and the recovered liquid is supplied to the substrate W, the cup 80 is elevated until the cup 80 is positioned laterally to the substrate W.

The cup 80 traps the processing liquid scattering around the substrate W by the rotation of the substrate W. For example, when the chemical liquid supplying portion 30 supplies the chemical liquid to the rotating substrate W, the chemical liquid scatters laterally from the substrate W. In this case, the cup 80 traps, at the upper position, the chemical liquid scattering laterally from the substrate W. Also, in a case where the rinse liquid supplying portion 40 supplies the rinse liquid to the rotating substrate W, the cup 80 traps, at the upper position, the rinse liquid scattering laterally from the substrate W. Similarly, in a case where the rear surface processing liquid supplying portion 50 supplies the processing liquid to the rotating substrate W, the cup 80 traps, at the upper position, the processing liquid scattering laterally from the substrate W.

As described above, while any one of the chemical liquid supplying portion 30, the rinse liquid supplying portion 40, and the rear surface processing liquid supplying portion 50 supplies any one of the chemical liquid, the rinse liquid, and the processing liquid to the substrate W, the cup 80 traps, at the upper position, any one of the chemical liquid, the rinse liquid, and the processing liquid scattering laterally from the substrate W. Also, when a period in which any one of the chemical liquid supplying portion 30, the rinse liquid supplying portion 40, and the rear surface processing liquid supplying portion 50 supplies any one of the chemical liquid, the rinse liquid, and the processing liquid to the substrate W ends, the cup 80 is lowered to the lower position that is positioned obliquely below the substrate W.

Specifically, when the chemical liquid supplying portion 30 and/or the chemical liquid supplying portion 54 supplies the chemical liquid to the substrate W while the substrate holding portion 20 holds and rotates the substrate W, the chemical liquid supplied to the substrate W scatters around the substrate W by the rotation of the substrate W. The cup 80 is positioned at the upper position that covers a side portion of the substrate W when the chemical liquid supplying portion 30 and/or the chemical liquid supplying portion 54 supplies the chemical liquid to the substrate W, and the cup 80 traps the chemical liquid scattering around the substrate W by the rotation of the substrate W. Similarly, when the rinse liquid supplying portion 40 and/or the rinse liquid supplying portion 56 supplies the rinse liquid to the substrate W while the substrate holding portion 20 holds and rotates the substrate W, the rinse liquid supplied to the substrate W scatters around the substrate W by the rotation of the substrate W. The cup 80 is positioned at the upper position that covers the side portion of the substrate W when the rinse liquid supplying portion 40 and/or the rinse liquid supplying portion 56 supplies the rinse liquid to the substrate W, and the cup 80 traps the rinse liquid scattering around the substrate W by the rotation of the substrate W.

Further, when the recovered-liquid supplying portion 58 supplies the recovered liquid to the substrate W while the substrate holding portion 20 holds and rotates the substrate W, the recovered liquid supplied to the substrate W scatters around the substrate W by the rotation of the substrate W. The cup 80 is positioned at the upper position that covers the side portion of the substrate W when the recovered-liquid supplying portion 58 supplies the recovered liquid to the substrate W, and the cup 80 traps the recovered liquid scattering around the substrate W by the rotation of the substrate W. As described above, the cup 80 traps any one of the chemical liquid, the rinse liquid, and the recovered liquid scattering around the substrate W by the rotation of the substrate W.

The drain mechanism 90 discharges the chemical liquid, the rinse liquid, and/or the recovered liquid trapped in the cup 80. A piping is connected to the cup 80, and the chemical liquid, the rinse liquid, and/or the recovered liquid trapped in the cup 80 flows through the piping and is discharged to the outside. It is noted that, the drain mechanism 90 may be connected to the recovered-liquid storage tank 210.

The recovered liquid obtained by recovering a liquid is stored in the recovered-liquid storage tank 210. The recovered-liquid storage tank 210 may store, as the recovered liquid, a liquid once used. For example, the recovered-liquid storage tank 210 may store a processing liquid in an adjustment process as a recovered liquid without discarding the processing liquid. In one example, the recovered-liquid storage tank 210 does not have to recover a liquid in a case where a particle concentration in the liquid is high, and may recover a liquid when a particle concentration in the liquid is low. Alternatively, the recovered-liquid storage tank 210 may store a cleaning liquid used to clean a member as the recovered liquid without discarding the cleaning liquid.

The drain mechanism 90 discharges the chemical liquid, the rinse liquid, and the processing liquid trapped in the cup 80 to the outside of the chamber 11. The drain mechanism 90 includes a piping 91 to discharge the chemical liquid, the rinse liquid, and the processing liquid trapped in the cup 80. One end of the piping 91 is connected to a bottom portion of the cup 80.

The drain mechanism 90 further includes a piping 92a and a valve 92b. The piping 92a is connected to the piping 91. The chemical liquid and the rinse liquid trapped in the cup 80 flow from the piping 91 to the piping 92a. The valve 92b opens and closes a flow channel in the piping 92a. The valve 92b adjusts an opening degree of the piping 92a to adjust a flow rate of the liquid flowing in the piping 92a. Specifically, the valve 92b includes a valve body (not shown) with a valve seat provided in an interior, a valve element which opens/closes the valve seat, and an actuator (not shown) which moves the valve element between an open position and a closed position.

As described above, the controller 101 includes the controlling portion 102 and the storage portion 104. The controlling portion 102 controls the substrate holding portion 20, the chemical liquid supplying portion 30, and/or the cup 80. In one example, the controlling portion 102 controls the electric motor 24, the valves 36, 46, 54b, 56b, 58b, and 92b, and/or the cup 80.

The substrate processing apparatus 100 of the present preferred embodiment is suitably used for manufacturing a semiconductor device provided with a semiconductor. Typically, in a semiconductor device, a conductive layer and an insulating layer are laminated on a base material. The substrate processing apparatus 100 is suitably used for cleaning and/or processing (for example, etching, characteristic change, and the like) of the conductive layer and/or the insulating layer at the time of manufacturing the semiconductor device.

It is noted that, in the substrate processing unit 10 illustrated in FIG. 2, the chemical liquid supplying portion 30 can supply one type of processing liquid. However, the present preferred embodiment is not limited thereto. The chemical liquid supplying portion 30 may supply a plurality of types of chemical liquids. For example, the chemical liquid supplying portion 30 may be capable of sequentially supplying a plurality of types of chemical liquids for different purposes to the substrate W. Alternatively, the chemical liquid supplying portion 30 may be capable of simultaneously supplying a plurality of types of chemical liquids for different purposes to the substrate W.

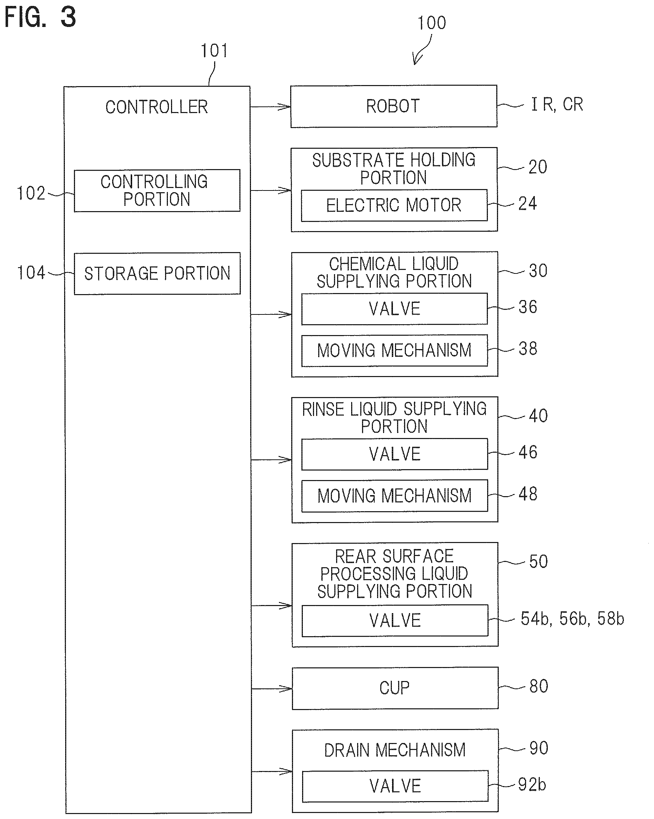

Next, the substrate processing apparatus 100 according to the present preferred embodiment will be described with reference to FIGS. 1 to 3. FIG. 3 is a block diagram of the substrate processing apparatus 100.

As illustrated in FIG. 3, the controller 101 controls various operations of the substrate processing apparatus 100. The controller 101 controls the indexer robot IR, the center robot CR, the substrate holding portion 20, the chemical liquid supplying portion 30, the rinse liquid supplying portion 40, the rear surface processing liquid supplying portion 50, the cup 80, and the drain mechanism 90. Specifically, the controller 101 controls the indexer robot IR, the center robot CR, the substrate holding portion 20, the chemical liquid supplying portion 30, the rinse liquid supplying portion 40, the rear surface processing liquid supplying portion 50, the cup 80, and the drain mechanism 90 by transmitting a control signal to the indexer robot IR, the center robot CR, the substrate holding portion 20, the chemical liquid supplying portion 30, the rinse liquid supplying portion 40, the rear surface processing liquid supplying portion 50, the cup 80, and the drain mechanism 90.

Also, the storage portion 104 stores a computer program and data. The data includes recipe data. The recipe data includes information indicating a plurality of recipes. Each of the plurality of recipes defines processing details, a processing procedure, and a substrate processing condition of the substrate W. The controlling portion 102 executes a computer program stored in the storage portion 104 to execute a substrate processing operation.

The controlling portion 102 controls the indexer robot IR to transfer the substrate W by the indexer robot IR.

The controlling portion 102 controls the center robot CR to transfer the substrate W by the center robot CR. For example, the center robot CR receives the unprocessed substrate W and carries the substrate W into one of the plurality of chambers 11. Also, the center robot CR receives the processed substrate W from the chamber 11 and carries out the substrate W.

The controlling portion 102 controls the substrate holding portion 20 to control a start of rotation of the substrate W, a change in rotation speed, and a stop of rotation of the substrate W. For example, the controlling portion 102 can control the substrate holding portion 20 to change a rotation speed of the substrate holding portion 20. Specifically, the controlling portion 102 can change a rotation speed of the substrate W by changing a rotation speed of the electric motor 24 of the substrate holding portion 20.

The controlling portion 102 can control the valve 36 of the chemical liquid supplying portion 30 to switch a state of the valve 36 between the open state and the closed state. Specifically, the controlling portion 102 can control the valve 36 of the chemical liquid supplying portion 30 to make the valve 36 in an open state, thereby enabling the chemical liquid flowing in the piping 32 toward the nozzle 34 to pass therethrough. Also, the controlling portion 102 can control the valve 36 of the chemical liquid supplying portion 30 to make the valve 36 in a closed state, thereby enabling the supply of the chemical liquid flowing in the piping 32 toward the nozzle 34 to be stopped.

The controlling portion 102 can control the valve 46 of the rinse liquid supplying portion 40 to switch a state of the valve 46 between the open state and the closed state. Specifically, the controlling portion 102 can control the valve 46 of the rinse liquid supplying portion 40 to make the valve 46 in an open state, thereby enabling the rinse liquid flowing in the piping 42 toward the nozzle 44 to pass therethrough. Also, the controlling portion 102 can control the valve 46 of the rinse liquid supplying portion 40 to make the valve 46 in a closed state, thereby enabling the supply the rinse liquid flowing in the piping 42 toward the nozzle 44 to be stopped.

The controlling portion 102 can control the valve 54b of the chemical liquid supplying portion 54 to switch a state of the valve 54b between the open state and the closed state. Specifically, the controlling portion 102 can control the valve 54b of the chemical liquid supplying portion 54 to make the valve 54b in an open state, thereby enabling the chemical liquid flowing in the piping 54a, the piping 52c, and the piping 52 toward the nozzle 51 to pass therethrough. Also, the controlling portion 102 can control the valve 54b of the chemical liquid supplying portion 54 to make the valve 54b in a closed state, thereby enabling the supply of the chemical liquid flowing in the piping 54a toward the nozzle 51 to be stopped.

The controlling portion 102 can control the valve 56b of the rinse liquid supplying portion 56 to switch a state of the valve 56b between the open state and the closed state. Specifically, the controlling portion 102 can control the valve 56b of the rinse liquid supplying portion 56 to make the valve 56b in an open state, thereby enabling the rinse liquid flowing in the piping 56a, the piping 52c, and the piping 52 toward the nozzle 51 to pass therethrough. Specifically, the controlling portion 102 can control the valve 56b of the rinse liquid supplying portion 56 to make the valve 56b in a closed state, thereby enabling the supply the rinse liquid flowing in the piping 56a toward the nozzle 51 to be stopped.

The controlling portion 102 can control the valve 58b of the recovered-liquid supplying portion 58 to switch a state of the valve 58b between the open state and the closed state. Specifically, the controlling portion 102 can control the valve 58b of the recovered-liquid supplying portion 58 to make the valve 58b in an open state, thereby enabling the recovered liquid flowing in the piping 58a, the piping 52c, and the piping 52 toward the nozzle 51 to pass therethrough. Also, the controlling portion 102 can control the valve 58b of the recovered-liquid supplying portion 58 to make the valve 58b in a closed state, thereby enabling the supply of the recovered liquid flowing in the piping 58a toward the nozzle 51 to be stopped.

The controlling portion 102 may control the cup 80 to move the cup 80 with respect to the substrate W. Specifically, the controlling portion 102 moves the cup 80 to an elevated position laterally to the substrate W in a period in which at least one of the chemical liquid supplying portion 30, the rinse liquid supplying portion 40, the chemical liquid supplying portion 54, the rinse liquid supplying portion 56, and the recovered-liquid supplying portion 58 supplies any one of the chemical liquid, the rinse liquid, and the recovered liquid to the substrate W. Also, when the period in which at least one of the chemical liquid supplying portion 30, the rinse liquid supplying portion 40, the chemical liquid supplying portion 54, the rinse liquid supplying portion 56, and the recovered-liquid supplying portion 58 supplies any one of the chemical liquid, the rinse liquid, and the recovered liquid to the substrate W ends, the controlling portion 102 lowers the cup 80 vertically downward from the lateral side of the substrate W.

The controlling portion 102 can control the valve 92b of the drain mechanism 90 to switch a state of the valve 92b between the open state and the closed state. Specifically, the controlling portion 102 can control the valve 92b to make the valve 92b in an open state, thereby enabling the chemical liquid and the rinse liquid flowing in the piping 91 and the piping 92a to pass therethrough. Specifically, the controlling portion 102 can control the valve 92b to make the valve 92b in a closed state, thereby enabling passing of the chemical liquid and the rinse liquid flowing in the piping 91 and the piping 92a to be stopped.

It is noted that, the controlling portion 102 may determine whether or not to recover, as a recovered liquid, the liquid into the recovered-liquid storage tank 210. For example, the controlling portion 102 may determine whether or not to recover, as the recovered liquid, the liquid into the recovered-liquid storage tank 210 based on measurement results of various measuring members.

The substrate processing apparatus 100 of the present preferred embodiment is suitably used for forming a semiconductor device. For example, the substrate processing apparatus 100 is suitably used for processing the substrate W used as a semiconductor device having a laminated structure. The semiconductor device is a memory (storage) having a so-called 3D structure. As an example, the substrate W is suitably used as a NAND type flash memory.

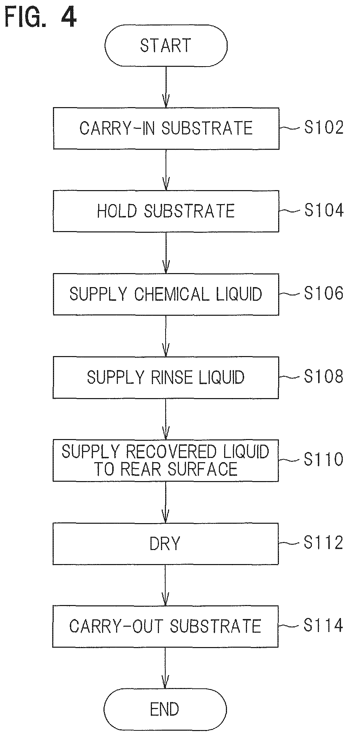

Next, the substrate processing apparatus 100 according to the present preferred embodiment will be described with reference to FIGS. 1 to 4. FIG. 4 is a flowchart of a substrate processing method according to the present preferred embodiment.

As illustrated in FIG. 4, in step S102, the substrate W is carried into the chamber 11. Under control of the controlling portion 102, the center robot CR carries the substrate W into the chamber 11. Here, the front surface Wa of the substrate W faces vertically upward, and the rear surface Wb of the substrate W faces vertically downward.

In step S104, the substrate holding portion 20 holds the carried-in substrate W. Under control of the controlling portion 102, the substrate holding portion 20 holds the substrate W.

In step S106, the rotation of the substrate W is started, and the chemical liquid is supplied to the substrate W. Under control of the controlling portion 102, the substrate holding portion 20 starts rotating the substrate W in a state of holding the substrate W. Also, under control of the controlling portion 102, the chemical liquid supplying portion 30 supplies the chemical liquid from the nozzle 34 to the front surface Wa of the substrate W.

It is noted that, while the chemical liquid is supplied from the nozzle 34 to the front surface Wa of the substrate W, the rear surface processing liquid supplying portion 50 may supply the chemical liquid from the nozzle 51 to the rear surface Wb of the substrate W under control of the controlling portion 102.

Under control of the controlling portion 102, the cup 80 is positioned at the upper position that covers the lateral side of the substrate W. The cup 80 may be elevated such as to be positioned laterally to the substrate W when the chemical liquid starts to be supplied from the nozzle 34 to the front surface Wa of the substrate W. It is noted that, the cup 80 may be elevated at the same timing as the start of supplying the processing liquid to the substrate W.

Under control of the controlling portion 102, the valve 92b is in an open state. In this case, the cup 80 traps the chemical liquid scattering from the substrate W, and the chemical liquid trapped in the cup 80 flows and is discharged through the piping 92a in which the valve 92b is opened.

In step S108, the rinse liquid is supplied to the substrate W in a state in which the substrate W is rotated. Under control of the controlling portion 102, the substrate holding portion 20 continues rotating the substrate W in the state of holding the substrate W. Also, under control of the controlling portion 102, the rinse liquid supplying portion 40 supplies the rinse liquid from the nozzle 44 to the front surface Wa of the substrate W.

It is noted that, while the rinse liquid is supplied from the nozzle 44 to the front surface Wa of the substrate W, the rear surface processing liquid supplying portion 50 may supply the rinse liquid from the nozzle 51 to the rear surface Wb of the substrate W under control of the controlling portion 102.

Under control of the controlling portion 102, the cup 80 remains positioned at the upper position that covers the lateral side of the substrate W. Under control of the controlling portion 102, the valve 92b is in an open state. In this case, the cup 80 traps the rinse liquid scattering from the substrate W, and the rinse liquid trapped in the cup 80 flows and is discharged through the piping 91 and the piping 92a in which the valve 92b is opened.

In step S110, the recovered liquid is supplied to the substrate W in the state in which the substrate W is rotated. Under control of the controlling portion 102, the substrate holding portion 20 continues rotating the substrate W in the state of holding the substrate W. Under control of the controlling portion 102, the rinse liquid supplying portion 40 continues supplying the rinse liquid from the nozzle 44 to the front surface Wa of the substrate W. Under control of the controlling portion 102, the rear surface processing liquid supplying portion 50 supplies the recovered liquid from the nozzle 51 to the rear surface Wb of the substrate W.

Under control of the controlling portion 102, the valve 92b is in an open state. In this case, the cup 80 traps the rinse liquid and the recovered liquid scattering from the substrate W, and the rinse liquid and the recovered liquid trapped in the cup 80 flows and is discharged through the piping 91 and the piping 92a in which the valve 92b is opened.

In step S112, the substrate W is dried. At this time, the supply of the rinse liquid and the recovered liquid is stopped, and the rotation speed of the substrate W is increased. Under control of the controlling portion 102, the chemical liquid supplying portion 30 stops supplying of the rinse liquid from the nozzle 34 to the front surface Wa of the substrate W. Also, under control of the controlling portion 102, the supply of the recovered liquid from the nozzle 51 to the rear surface Wb of the substrate W is stopped. Further, under the control of the controlling portion 102, the substrate holding portion 20 increases the rotation speed of the substrate W.

Also, under control of the controlling portion 102, the cup 80 remains positioned at the upper position that covers the lateral side of the substrate W. Under control of the controlling portion 102, the valve 92b remains closed. In this case, the cup 80 traps the rinse liquid and the recovered liquid scattering from the substrate W, and the rinse liquid and the recovered liquid trapped in the cup 80 flows and is discharged through the piping 91 and the piping 92a in which the valve 92b is opened. Thereafter, under control of the controlling portion 102, the substrate holding portion 20 stops the rotation of the substrate W.

In step S114, the substrate W is carried out from the substrate processing unit 10. Under control of the controlling portion 102, the substrate holding portion 20 releases the holding of the substrate W, and the center robot CR takes out the substrate W from the chamber 11. Thereafter, the substrate W is carried to the outside of the substrate processing apparatus 100 through the indexer robot IR.

In the present preferred embodiment, the front surface Wa of the substrate W is processed with the chemical liquid as described above, and then processed with the rinse liquid. According to the present preferred embodiment, in at least a part of the period in which the rinse liquid supplying portion 40 supplies the rinse liquid to the front surface Wa of the substrate W, the recovered liquid is supplied to the rear surface Wb of the substrate W. Therefore, the substrate processing apparatus 100 according to the present preferred embodiment can reduce the use amount of a new processing liquid.

Also, in the present preferred embodiment, in the period in which the rinse liquid is supplied to the front surface Wa of the substrate W, the recovered liquid is supplied to the rear surface Wb of the substrate W after a predetermined time elapses. Consequently, at the start of the rinse processing, since the rinse liquid containing relatively less impurities is supplied also to the rear surface Wb of the substrate W, it is possible to more appropriately perform the rinse processing on the substrate W.

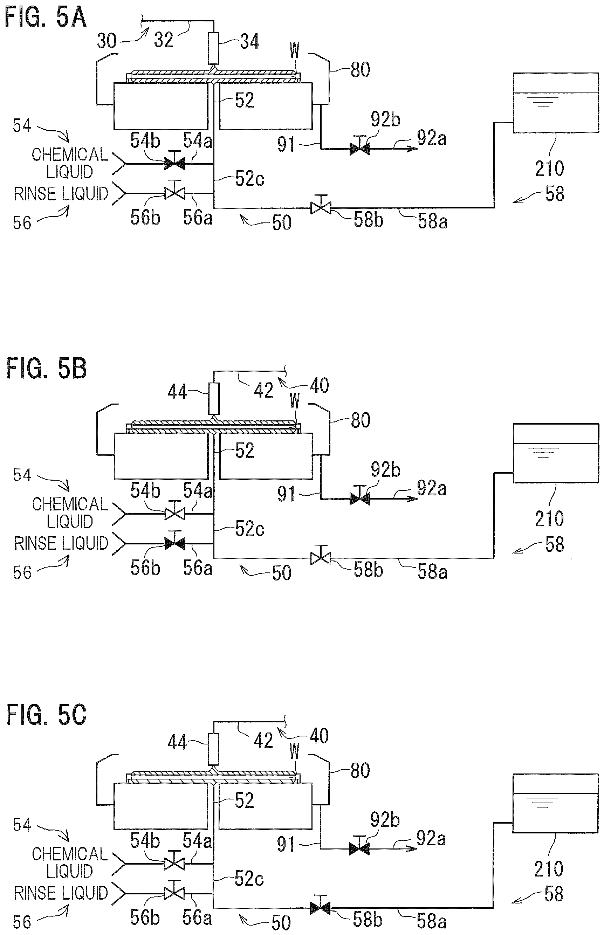

Next, the substrate processing apparatus 100 according to the present preferred embodiment will be described with reference to FIGS. 1 to 5C. FIGS. 5A to 5C are schematic diagrams illustrating a flow of the substrate processing apparatus 100 according to the present preferred embodiment.

As illustrated in FIG. 5A, the chemical liquid is supplied to the front surface Wa and the rear surface Wb of the substrate W, and the front surface Wa and the rear surface Wb of the substrate W are processed with the chemical liquid. FIG. 5A illustrates an example of step S106 in FIG. 4. The chemical liquid supplying portion 30 supplies the chemical liquid to the front surface Wa of the rotating substrate W. The rear surface processing liquid supplying portion 50 supplies the chemical liquid to the rear surface Wb of the rotating substrate W. Here, the cup 80 is positioned at the upper position. Therefore, the cup 80 faces the side portion of the substrate W. The cup 80 traps the chemical liquid scattering in accompaniment with the rotation of the substrate W.

In the drain mechanism 90, the valve 92b is opened. Therefore, the chemical liquid trapped in the cup 80 flows and is discharged through the piping 91 and the piping 92a.

As illustrated in FIG. 5B, the rinse liquid is supplied to the front surface Wa and the rear surface Wb of the substrate W, and the front surface Wa and the rear surface Wb of the substrate W are processed with the rinse liquid. FIG. 5B illustrates an example of step S108 in FIG. 4. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 92b remains open. Therefore, the rinse liquid trapped in the cup 80 flows and is discharged through the piping 91 and the piping 92a.

As illustrated in FIG. 5C, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. FIG. 5C illustrates an example of step S110 in FIG. 4. For example, the rinse liquid supplying portion 40 continues supplying the rinse liquid to the front surface Wa of the rotating substrate W. The rear surface processing liquid supplying portion 50 supplies the recovered liquid to the rear surface Wb of the rotating substrate W. The cup 80 traps the rinse liquid scattering in accompaniment with the rotation of the substrate W and traps the recovered liquid scattering in accompaniment with the rotation of the substrate W.

In the drain mechanism 90, the valve 92b remains open. Therefore, the rinse liquid and the recovered liquid trapped in the cup 80 flow and are discharged through the piping 91 and the piping 92a.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

According to the present preferred embodiment, the front surface Wa of the substrate W is processed with the chemical liquid as described above, and then processed with the rinse liquid. According to the present preferred embodiment, in at least a part of the period in which the rinse liquid supplying portion 40 supplies the rinse liquid to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, the recovered liquid stored in the recovered-liquid storage tank 210 is recovered as follows.

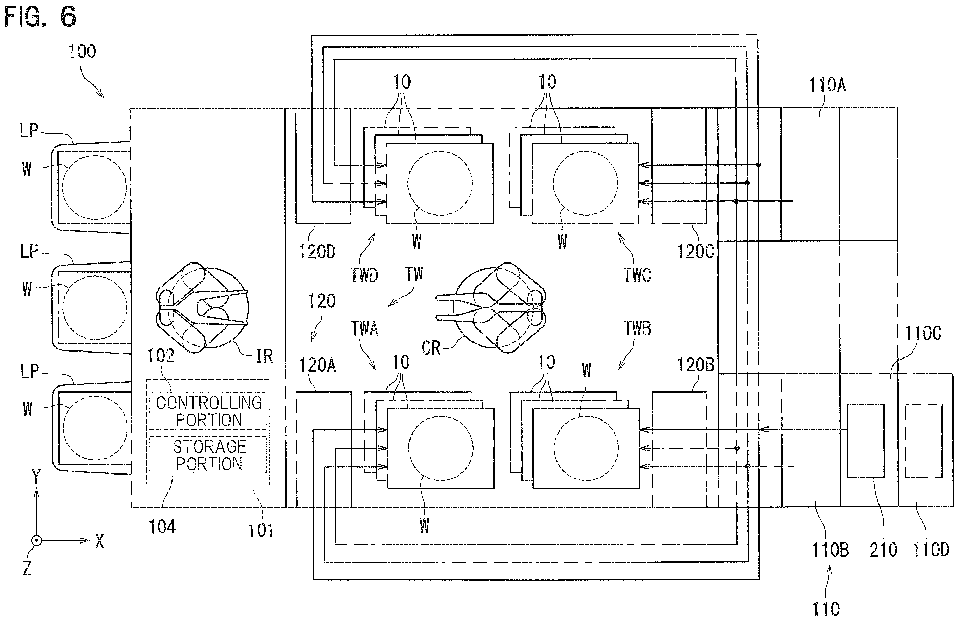

Next, the substrate processing apparatus 100 according to the present preferred embodiment will be described with reference to FIGS. 1 to 6. FIG. 6 is a schematic plan view of the substrate processing apparatus 100 according to the present preferred embodiment. The substrate processing apparatus 100 in FIG. 6 has the same configuration as the substrate processing apparatus 100 illustrated in FIG. 1 except that the processing liquid cabinet 110 further includes a high-temperature liquid cabinet 110D, and redundant description will be omitted for the purpose of avoiding the lengthy description.

As illustrated in FIG. 6, in the substrate processing apparatus 100, the processing liquid cabinet 110 further includes the high-temperature liquid cabinet 110D. For example, the high-temperature liquid cabinet 110D prepares a high-temperature liquid. For example, in the high-temperature liquid cabinet 110D, the processing liquid is heated. Also, the high-temperature liquid cabinet 110D supplies the high-temperature liquid to the processing liquid box 120.

The high-temperature liquid cabinet 110D prepares a high-temperature liquid obtained by heating a liquid. The high-temperature liquid may contain any one of, for example, deionized water (DIW), carbonated water, electrolyzed ion water, ozone water, ammonia water, hydrochloric acid solution with a diluted concentration (for example, about 10 ppm to 100 ppm), and reduced water (hydrogen water). In one example, the high-temperature liquid has a temperature of 20°C or higher. For example, the high-temperature liquid may be a temperature of 30°C or higher and 100°C or lower.

The high-temperature liquid cabinet 110D may prepare a high-temperature liquid obtained by heating a rinse liquid or a cleaning liquid. For example, the high-temperature liquid is used as a rinse liquid for cleaning the substrate W treated with the chemical liquid. Alternatively, the high-temperature liquid may be used as the chemical liquid or one component of the chemical liquid.

For example, the high-temperature liquid cabinet 110D is disposed adjacent to the recovered-liquid cabinet 110C. For example, the high-temperature liquid cabinet 110D may be retrofitted to the existing processing liquid cabinet 110.

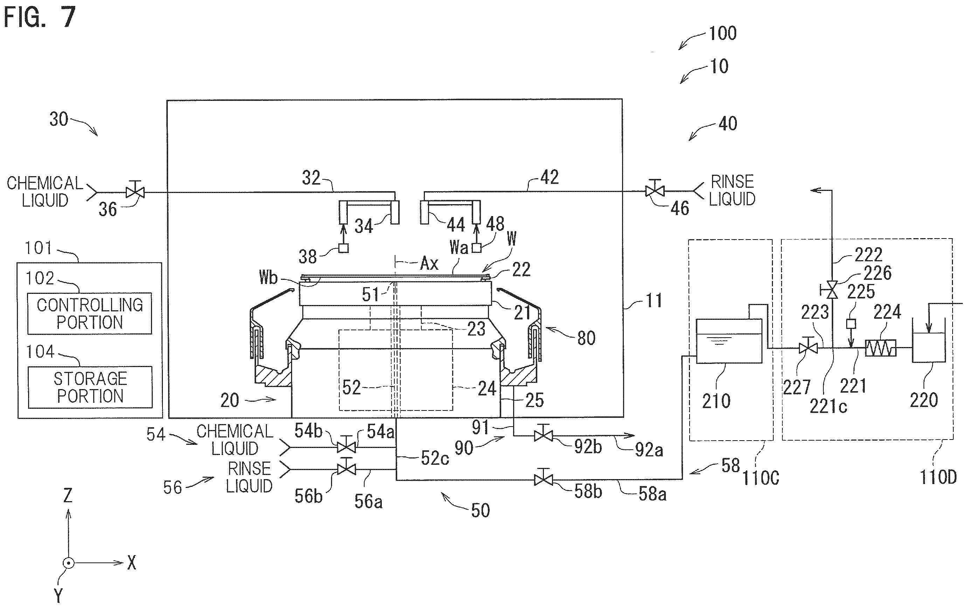

Next, the substrate processing apparatus 100 according to the present preferred embodiment will be described with reference to FIGS. 1 to 7. FIG. 7 is a schematic diagram of the substrate processing apparatus 100 according to the present preferred embodiment. The substrate processing apparatus 100 in FIG. 7 has the same configuration as the substrate processing apparatus 100 illustrated in FIG. 2 except that the high-temperature liquid and the recovered liquid are supplied from the high-temperature liquid cabinet 110D, and redundant description is omitted in order to avoid the lengthy description.

As illustrated in FIG. 7, the substrate processing apparatus 100 includes the high-temperature liquid cabinet 110D. The high-temperature liquid cabinet 110D prepares a high-temperature liquid obtained by heating a liquid to a high temperature. The high-temperature liquid is used as at least a part of the chemical liquid and/or the rinse liquid for processing the substrate W in the substrate processing unit 10. The high-temperature liquid during preparation may be recovered as a recovered liquid.

The high-temperature liquid cabinet 110D includes a storage tank 220, a piping 221, a piping 222, a piping 223, a heater 224, a temperature measuring portion 225, a valve 226, and a valve 227. The storage tank 220 stores a liquid before the liquid is heated to obtain the high-temperature liquid. The piping 221 connects the storage tank 220, the piping 222, and the piping 223. The piping 221, the piping 222, and the piping 223 are connected at a connection point 221c. One end of the piping 221 is connected to the storage tank 220, and the other end of the piping 221 is connected to the connection point 221c.

The heater 224 is attached to the piping 221. The heater 224 heats a liquid flowing in the piping 221. The liquid flowing in the piping 221 is prepared as a high-temperature liquid by the heater 224.

The temperature measuring portion 225 (temperature sensor) is attached to the piping 221. The temperature measuring portion 225 measures a temperature of the high-temperature liquid flowing in the piping 221. Typically, the temperature measuring portion 225 is positioned on the piping 221 more downstream than the heater 224.

The piping 222 connects the substrate processing unit 10 and the connection point 221c through the processing liquid box 120. Therefore, the high-temperature liquid flowing in the piping 222 is used as the processing liquid of the substrate processing unit 10. The valve 226 is attached to the piping 222. The valve 226 adjusts an opening degree of the piping 222 to adjust a flow rate of the high-temperature liquid flowing in the piping 222.

The piping 223 connects the recovered-liquid storage tank 210 and the connection point 221c. Therefore, the high-temperature liquid flowing in the piping 223 is recovered in the recovered-liquid storage tank 210. The valve 227 is attached to the piping 223. The valve 227 adjusts an opening degree of the piping 223 to adjust a flow rate of the high-temperature liquid flowing in the piping 223.

In a case where a temperature of the high-temperature liquid measured by the temperature measuring portion 225 reaches a predetermined temperature, the controlling portion 102 opens the valve 226 and closes the valve 227 so that the high-temperature liquid flows to the substrate processing unit 10 through the piping 222. On the other hand, in a case where the temperature of the high-temperature liquid measured by the temperature measuring portion 225 does not reach the predetermined temperature, the controlling portion 102 closes the valve 226 and opens the valve 227, thereby causing the high-temperature liquid to flow to the recovered-liquid storage tank 210 through the piping 223.

As described above, the recovered-liquid storage tank 210 recovers the high-temperature liquid, as the recovered liquid, until the high-temperature liquid prepared in the high-temperature liquid cabinet 110D reaches the predetermined temperature. The recovered liquid recovered in the recovered-liquid storage tank 210 is supplied to the rear surface Wb of the substrate W. Therefore, the substrate processing apparatus 100 according to the present preferred embodiment can reduce the use amount of a new processing liquid.

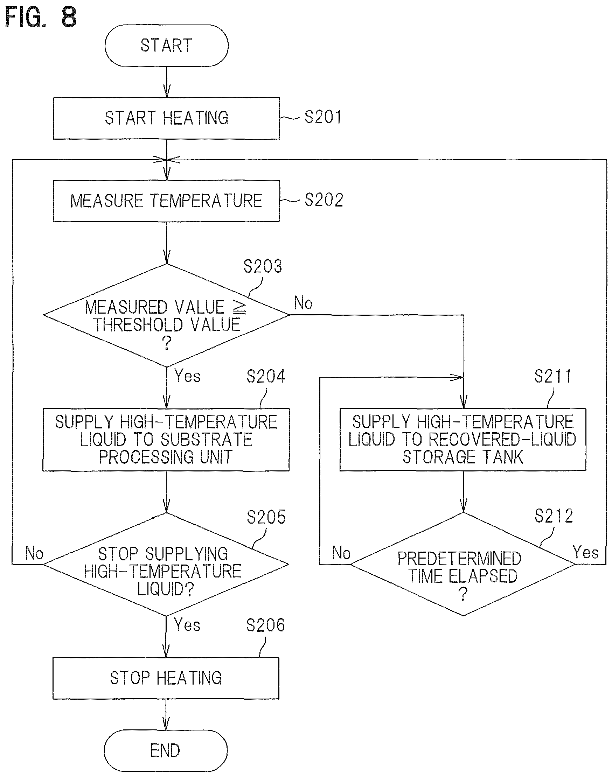

Next, the substrate processing apparatus 100 according to the present preferred embodiment will be described with reference to FIGS. 1 to 8. FIG. 8 is a flowchart of the substrate processing method according to the present preferred embodiment.

As illustrated in FIG. 8, in step S201, heating by the heater 224 is started. The controlling portion 102 drives a pump (not illustrated) such that the high-temperature liquid heated by the heater 224 flows in the piping 221.

In step S202, the temperature is measured. The controlling portion 102 causes the temperature measuring portion 225 to measure a temperature of the high-temperature liquid flowing in the piping 221.

In step S203, it is determined whether or not a measured value of the temperature is equal to or larger than a threshold value. The controlling portion 102 compares the measured value of the temperature measuring portion 225 with the threshold value and determines whether or not the measured value is equal to or larger than the threshold value.

In a case where it is determined that the measured value of the temperature is equal to or larger than the threshold value (Yes in step S203), the process proceeds to step S204. On the other hand, in a case where it is determined that the measured value of the temperature is smaller than the threshold value (No in step S203), the process proceeds to step S211 again.

In step S204, the high-temperature liquid is supplied to the substrate processing unit 10. The controlling portion 102 opens the valve 226 and closes the valve 227, thereby supplying the high-temperature liquid to the substrate processing unit 10 through the piping 222.

In step S205, it is determined whether or not to stop the supply of the high-temperature liquid. For example, the controlling portion 102 determines whether or not the high-temperature liquid needs to be more supplied for processing the substrate W.

In a case where it is determined not to stop the supply of the high-temperature liquid (No in step S205), the process returns to step S202. On the other hand, in a case where it is determined to stop the supply of the high-temperature liquid (Yes in step S205), the process proceeds to step S206.

In step S206, heating is stopped. The controlling portion 102 stops heating of the heater 224 and stops driving of the pump. Thereafter, the process ends.

In step S211, the high-temperature liquid is supplied to the recovered-liquid storage tank 210. The controlling portion 102 closes the valve 226 and opens the valve 227, thereby recovering the high-temperature liquid in the recovered-liquid storage tank 210 through the piping 223.

In step S212, it is determined whether or not a predetermined time has elapsed after the start of the supply of the high-temperature liquid to the recovered-liquid storage tank 210. For example, the controlling portion 102 measures an elapsed time after the start of the supply of the high-temperature liquid, and determines whether or not the elapsed time is equal to or longer than a threshold value.

In a case where it is determined that the predetermined time has not elapsed (No in step S212), the process proceeds to step S211 again, and this determination is repeatedly performed until the predetermined time elapses. On the other hand, in a case where it is determined that the predetermined time has elapsed (Yes in step S212), the process returns to step S202. Thereafter, in step S202, the temperature is measured again and the determination is repeated.

According to the present preferred embodiment, the controlling portion 102 determines whether or not to store the high-temperature liquid, as the recovered liquid, in the recovered-liquid storage tank 210 based on a measurement result of the temperature measuring portion 225. At this time, the high-temperature liquid having a temperature lower than the threshold value despite being heated by the heater 224 is recovered in the recovered-liquid storage tank 210 as a recovered liquid. As described above, the recovered liquid in the recovered-liquid storage tank 210 is supplied to the rear surface Wb of the substrate W in at least a part of the period in which the rinse liquid supplying portion 40 supplies the rinse liquid to the front surface Wa of the substrate W. Therefore, the substrate processing apparatus 100 according to the present preferred embodiment can reduce the use amount of a new processing liquid.

It is noted that, in the above description with reference to FIGS. 6 to 8, the processing liquid cabinet 110 includes the high-temperature liquid cabinet 110D that heats a liquid, but the present preferred embodiment is not limited thereto. The rinse liquid may be heated in the rinse liquid cabinet 110B, while processing liquid cabinet 110 not including the high-temperature liquid cabinet 110D, and the. In this case, the rinse liquid having a temperature lower than the threshold value may be recovered in the recovered-liquid storage tank 210. Similarly, the chemical liquid may be heated in the chemical liquid cabinet 110A. In this case, the chemical liquid having a temperature lower than the threshold value may be recovered in the recovered-liquid storage tank 210.

Also, in the above description with reference to FIGS. 6 to 8, it is determined whether or not to recover the liquid in the recovered-liquid storage tank 210 based on the temperature of the liquid, but the present preferred embodiment is not limited thereto. Whether or not to recover the liquid in the recovered-liquid storage tank 210 may be determined based on a concentration of the liquid.

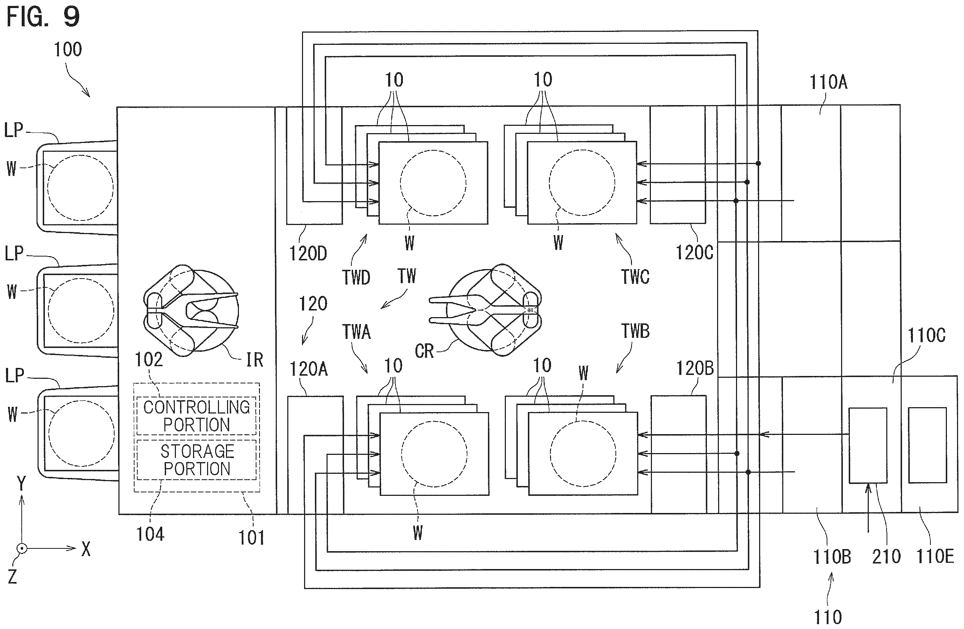

Next, the substrate processing apparatus 100 according to the present preferred embodiment will be described with reference to FIGS. 1 to 9. FIG. 9 is a schematic plan view of the substrate processing apparatus 100 according to the present preferred embodiment. The substrate processing apparatus 100 in FIG. 9 has the same configuration as the substrate processing apparatus 100 illustrated in FIG. 1 except that the processing liquid cabinet 110 further includes an ozone liquid cabinet 110E, and redundant description will be omitted for the purpose of avoiding lengthy description.

As illustrated in FIG. 9, in the substrate processing apparatus 100, the processing liquid cabinet 110 further includes the ozone liquid cabinet 110E. The ozone liquid cabinet 110E prepares an ozone liquid. For example, in the ozone liquid cabinet 110E, an ozone gas is generated and dissolved in a liquid. The ozone liquid cabinet 110E supplies the ozone liquid to the processing liquid box 120.

Here, the ozone liquid cabinet 110E is disposed adjacent to the recovered-liquid cabinet 110C. For example, the ozone liquid cabinet 110E may be retrofitted to the existing processing liquid cabinet 110.

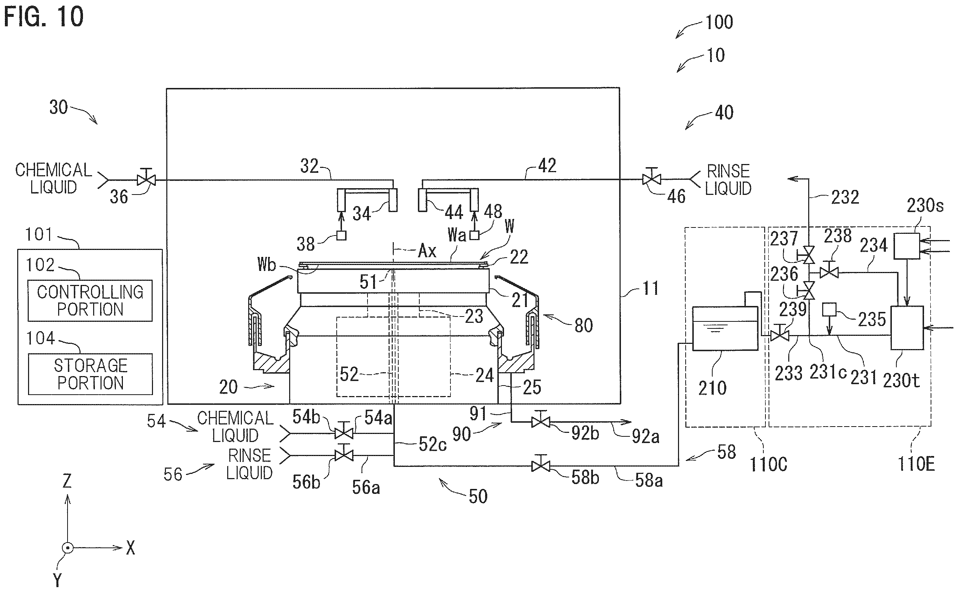

Next, the substrate processing apparatus 100 according to the present preferred embodiment will be described with reference to FIGS. 1 to 10. FIG. 10 is a schematic diagram of the substrate processing apparatus 100 according to the present preferred embodiment. The substrate processing apparatus 100 in FIG. 10 has the same configuration as the substrate processing apparatus 100 illustrated in FIG. 2 except that an ozone liquid cabinet 110E that supplies an ozone liquid is further provided, and redundant description will be omitted for the purpose of avoiding the lengthy description.

As illustrated in FIG. 10, in the substrate processing apparatus 100, the processing liquid cabinet 110 further includes the ozone liquid cabinet 110E. For example, the ozone liquid cabinet 110E prepares an ozone liquid. For example, in the ozone liquid cabinet 110E, an ozone gas is generated, and an ozone liquid is generated by dissolving the ozone gas in a liquid. Also, the ozone liquid cabinet 110E supplies the ozone liquid to the processing liquid box 120.

The liquid in which the ozone gas is dissolved may contain any one of, for example, deionized water (DIW), carbonated water, electrolyzed ion water, ozone water, ammonia water, hydrochloric acid solution with a diluted concentration (for example, about 10 ppm to 100 ppm), and reduced water (hydrogen water). For example, ozone water can be generated by dissolving the ozone gas in deionized water.

The ozone liquid cabinet 110E may generate an ozone liquid by dissolving the ozone gas in the rinse liquid or the cleaning liquid. For example, the ozone liquid is used as the rinse liquid for cleaning the substrate W treated with the chemical liquid. Alternatively, the ozone liquid may be used as the chemical liquid or one component of the chemical liquid.

The ozone liquid cabinet 110E prepares the ozone liquid obtained by dissolving the generated ozone gas in a liquid. The ozone liquid is used as at least a part of the chemical liquid and/or the rinse liquid for processing the substrate W in the substrate processing unit 10. The ozone liquid during preparation may be recovered as the recovered liquid.

The ozone liquid cabinet 110E includes an ozone gas generator 230s, an ozone gas dissolving tank 230t, a piping 231, a piping 232, a piping 233, a piping 234, a concentration measuring portion 235, a valve 236, a valve 237, a valve 238, and a valve 239. The ozone gas generator 230s generates an ozone gas. The ozone gas generator 230s generates the ozone gas from an oxygen gas and a carbon dioxide gas.

The ozone gas dissolving tank 230t is used to dissolve, in the liquid, the ozone gas generated in the ozone gas generator 230s. Consequently, an ozone liquid is generated.

The piping 231 connects the ozone gas dissolving tank 230t, the piping 232, and the piping 233. The piping 231, the piping 232, and the piping 233 are connected at a connection point 231c. One end of the piping 231 is connected to the ozone gas dissolving tank 230t, and the other end of the piping 231 is connected to the connection point 231c.

The concentration measuring portion 235 (concentration sensor) is attached to the piping 231. The concentration measuring portion 235 measures an ozone concentration in the ozone liquid flowing in the piping 231.

The piping 232 connects the substrate processing unit 10 and the connection point 231c through the processing liquid box 120. Therefore, the ozone liquid flowing in the piping 232 is used as the processing liquid of the substrate processing unit 10. The valves 236 and 237 are attached to the piping 232. The valves 236 and 237 adjust an opening degree of the piping 232 to adjust a flow rate of the ozone liquid flowing in the piping 232.

The piping 233 connects the recovered-liquid storage tank 210 and the connection point 231c. Therefore, the ozone liquid flowing in the piping 233 is recovered in the recovered-liquid storage tank 210. The valve 239 is attached to the piping 233. The valve 239 adjusts an opening degree of the piping 233 to adjust a flow rate of the ozone liquid flowing in the piping 233.

The piping 234 connects a position between the valve 236 and the valve 237 on the piping 232 and the recovered-liquid storage tank 210. Therefore, the ozone liquid flowing in the piping 232 and the piping 234 returns to the ozone gas dissolving tank 230t, and the ozone liquid is circulated. The valve 238 is attached to the piping 234. The valve 238 adjusts an opening degree of the piping 234 to adjust a flow rate of the ozone liquid flowing in the piping 234.

In a case where a concentration of the ozone liquid measured by the concentration measuring portion 235 reaches a predetermined concentration, the controlling portion 102 opens the valves 236 and 237 and closes the valves 238 and 239, thereby supplying the ozone liquid through the piping 232 to the substrate processing unit 10. Also, in a case where the concentration of the ozone liquid measured by the concentration measuring portion 235 falls within an intermediate concentration range, the controlling portion 102 opens the valves 236 and 238 and closes the valves 237 and 239, thereby circulating the ozone liquid through the piping 232 and the piping 234 to the ozone gas dissolving tank 230t. Further, in a case where the concentration of the ozone liquid measured by the concentration measuring portion 235 does not reach the predetermined concentration, the controlling portion 102 closes the valve 236 and opens the valve 239, thereby recovering the ozone liquid in the recovered-liquid storage tank 210 through the piping 233.

As described above, the ozone liquid prepared in the ozone liquid cabinet 110E is recovered as the recovered liquid in the recovered-liquid storage tank 210 until the concentration of the ozone liquid reaches an intermediate concentration with which circulation of the ozone liquid is started. As described above, the recovered liquid recovered in the recovered-liquid storage tank 210 is supplied to the rear surface Wb of the substrate W. Therefore, the substrate processing apparatus 100 according to the present preferred embodiment can reduce the use amount of a new processing liquid.

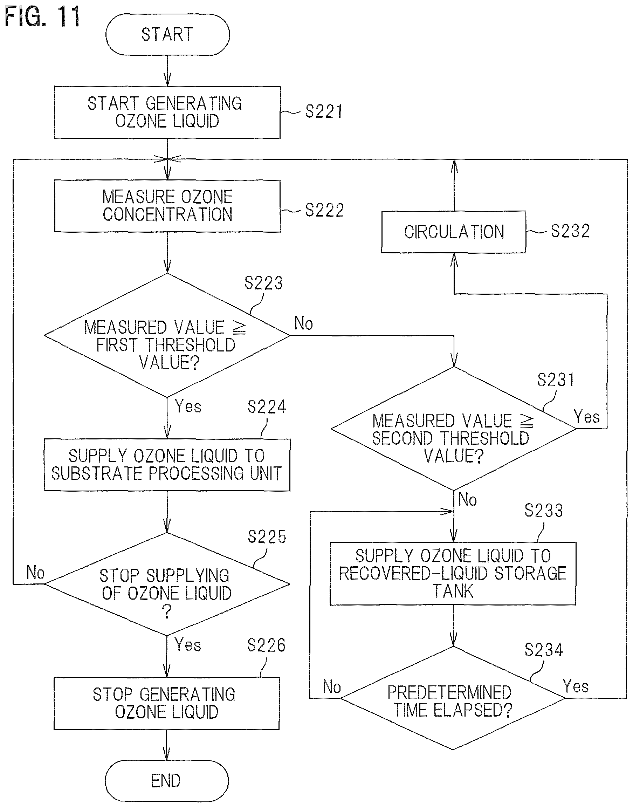

Next, the substrate processing apparatus 100 according to the present preferred embodiment will be described with reference to FIGS. 1 to 11. FIG. 11 is a flowchart of the substrate processing method according to the present preferred embodiment.

As illustrated in FIG. 11, in step S221, generation of the ozone liquid is started. The controlling portion 102 generates the ozone liquid obtained by dissolving the ozone gas generated by the ozone gas generator 230s in a liquid in the ozone gas dissolving tank 230t, and drives a pump (not illustrated) so that the ozone liquid flows in the piping 221.

In step S222, the concentration of the ozone liquid is measured. The controlling portion 102 causes the concentration measuring portion 235 to measure the concentration of the ozone liquid flowing in the piping 231.

In step S223, it is determined whether or not a measured value of the ozone concentration is equal to or larger than a first threshold value. The controlling portion 102 compares the measured value of the concentration measuring portion 235 with the first threshold value and determines whether or not the measured value is equal to or larger than the first threshold value.

In a case where it is determined that the measured value of the ozone concentration is equal to or larger than the first threshold value (Yes in step S223), the process proceeds to step S224. On the other hand, in a case where it is determined that the measured value of the ozone concentration is smaller than the first threshold value (No in step S223), the process proceeds to step S231.

In step S224, the ozone liquid is supplied to the substrate processing unit 10. The controlling portion 102 opens the valves 236 and 237 and closes the valves 238 and 239, thereby supplying the ozone liquid through the piping 232 to the substrate processing unit 10. Thereafter, the process proceeds to step S225.

In step S225, it is determined whether or not to stop the supply of the ozone liquid. For example, the controlling portion 102 determines whether or not the ozone liquid needs to be more supplied for processing the substrate W.

In a case where it is determined not to stop the supply of the ozone liquid (No in step S225), the process returns to step S222. On the other hand, in a case where it is determined to stop the supply of the ozone liquid (Yes in step S225), the process proceeds to step S226.

In step S226, the generation of the ozone liquid is stopped. The controlling portion 102 causes the ozone gas generator 230s to stop generation of the ozone gas and stop driving of the pump. Thereafter, the process ends.

In step S231, it is determined whether or not a measured value of the ozone concentration is equal to or larger than a second threshold value. The controlling portion 102 compares the measured value of the concentration measuring portion 235 with the second threshold value and determines whether or not the measured value is equal to or larger than the second threshold value. Here, the second threshold value is smaller than the first threshold value.

In a case where it is determined that the measured value of the ozone concentration is equal to or larger than the second threshold value (Yes in step S231), the process proceeds to step S232. On the other hand, in a case where it is determined that the measured value of the ozone concentration is smaller than the second threshold value (No in step S231), the process proceeds to step S233.

In step S232, the ozone liquid is circulated. The controlling portion 102 opens the valves 236 and 238 and closes the valves 237 and 239, thereby circulating the ozone liquid through the piping 232 and the piping 234 to the ozone gas dissolving tank 230t. Thereafter, the process returns to step S222.

In step S233, the ozone liquid is supplied to the recovered-liquid storage tank 210. The controlling portion 102 closes the valve 236 and opens the valve 239, thereby recovering the ozone liquid in the recovered-liquid storage tank 210 through the piping 233.

In step S234, it is determined whether or not a predetermined time has elapsed after the start of the supply of the ozone liquid to the recovered-liquid storage tank 210. For example, the controlling portion 102 measures an elapsed time after the start of the supply of the ozone liquid, and determines whether or not the elapsed time is equal to or longer than a threshold value.

In a case where it is determined that the predetermined time has not elapsed (No in step S234), the process proceeds to step S233 again, and this determination is repeatedly performed until the predetermined time elapses. On the other hand, in a case where it is determined that the predetermined time has elapsed (Yes in step S234), the process returns to step S222. Thereafter, in step S222, the concentration of the ozone liquid is measured again, and the subsequent steps are repeated.

According to the present preferred embodiment, generation of the ozone gas in the ozone gas generator 230s causes the ozone liquid having a concentration in the intermediate range of the second threshold value or higher and lower than the first threshold value to be circulated. Consequently, the concentration of the ozone liquid can be efficiently increased by dissolving the ozone gas generated in the ozone gas generator 230s while the ozone liquid having a concentration which is not sufficiently high but is relatively high is circulated.

Also, according to the present preferred embodiment, the controlling portion 102 determines whether or not to store the ozone liquid, as the recovered liquid, in the recovered-liquid storage tank 210 based on a measurement result of the concentration measuring portion 235. In this case, the ozone liquid having a concentration lower than the second threshold value despite the ozone gas being generated in the ozone gas generator 230s is recovered in the recovered-liquid storage tank 210 as a recovered liquid. As described above, the recovered liquid in the recovered-liquid storage tank 210 is supplied to the rear surface Wb of the substrate W in at least a part of the period in which the rinse liquid supplying portion 40 supplies the rinse liquid to the front surface Wa of the substrate W. Therefore, the substrate processing apparatus 100 according to the present preferred embodiment can reduce the use amount of a new processing liquid.

It is noted that, in the substrate processing apparatus 100 illustrated in FIG. 10, the ozone liquid having a low concentration is directly supplied to the recovered-liquid storage tank 210, but the present preferred embodiment is not limited thereto. Before the ozone liquid is supplied to the recovered-liquid storage tank 210, ozone may be evaporated from the ozone liquid.

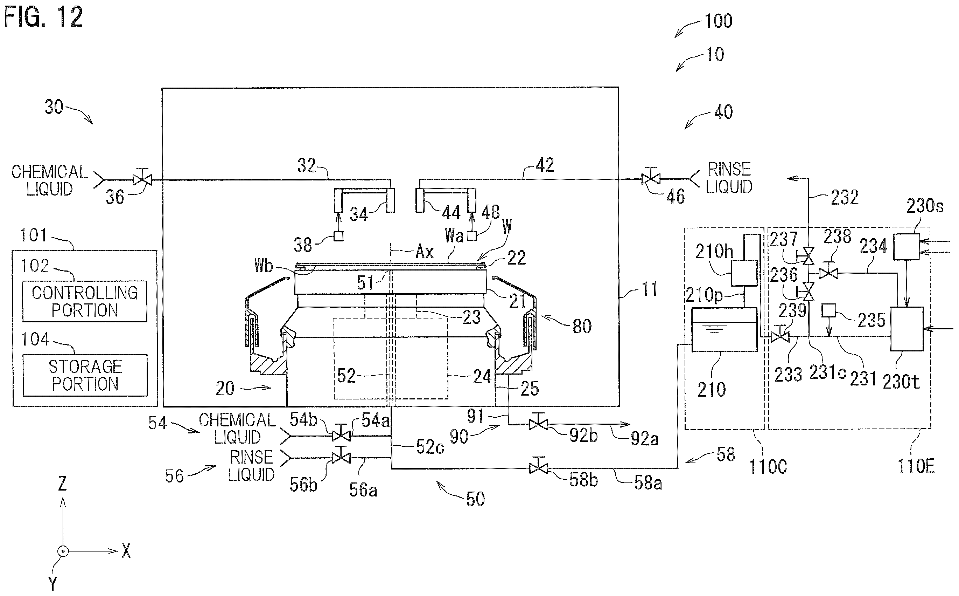

Next, the substrate processing apparatus 100 according to the present preferred embodiment will be described with reference to FIGS. 1 to 12. FIG. 12 is a schematic diagram of the substrate processing apparatus 100 according to the present preferred embodiment. The substrate processing apparatus 100 in FIG. 12 has the same configuration as the substrate processing apparatus 100 illustrated in FIG. 10 except that the recovered-liquid cabinet 110C includes a heating tank 210h in addition to the recovered-liquid storage tank 210, and redundant description is omitted in order to avoid the lengthy description.

As illustrated in FIG. 12, the recovered-liquid cabinet 110C includes the heating tank 210h in addition to the recovered-liquid storage tank 210. The heating tank 210h is connected to the piping 233. The heating tank 210h is connected to the recovered-liquid storage tank 210 through a piping 210p.

The ozone liquid flowing in the piping 233 is stored in the heating tank 210h. The heating tank 210h heats the ozone liquid flowing in through the piping 233. Heating of the ozone liquid having a relatively low concentration in the heating tank 210h enables ozone in the ozone liquid to be evaporated so that the ozone concentration in the ozone liquid can be further reduced. Hence, even when the recovered liquid stored in the recovered-liquid storage tank 210 is supplied to the rear surface Wb of the substrate W in at least a part of the period in which the rinse liquid supplying portion 40 supplies the rinse liquid to the front surface Wa of the substrate W, it is possible to prevent the fluctuation in the characteristic to the rear surface Wb of the substrate W. Therefore, the substrate processing apparatus 100 according to the present preferred embodiment can effectively reduce the use amount of a new processing liquid.

It is noted that, in the substrate processing apparatus 100 illustrated in FIG. 12, the ozone liquid is heated to reduce the ozone concentration of the ozone liquid, but the ozone liquid may be chemically processed to reduce the ozone concentration of the ozone liquid. For example, an alkaline chemical liquid may be added in ozone water to neutralize ozone in the ozone liquid.

It is noted that, in the above description with reference to FIGS. 6 to 12, the liquid in the process of preparing the processing liquid which is supplied to the substrate processing unit 10 that processes the substrates W is recovered in the recovered-liquid storage tank 210, but the present preferred embodiment is not limited thereto. A liquid unrelated to the process of preparing the processing liquid may be recovered in the recovered-liquid storage tank 210.

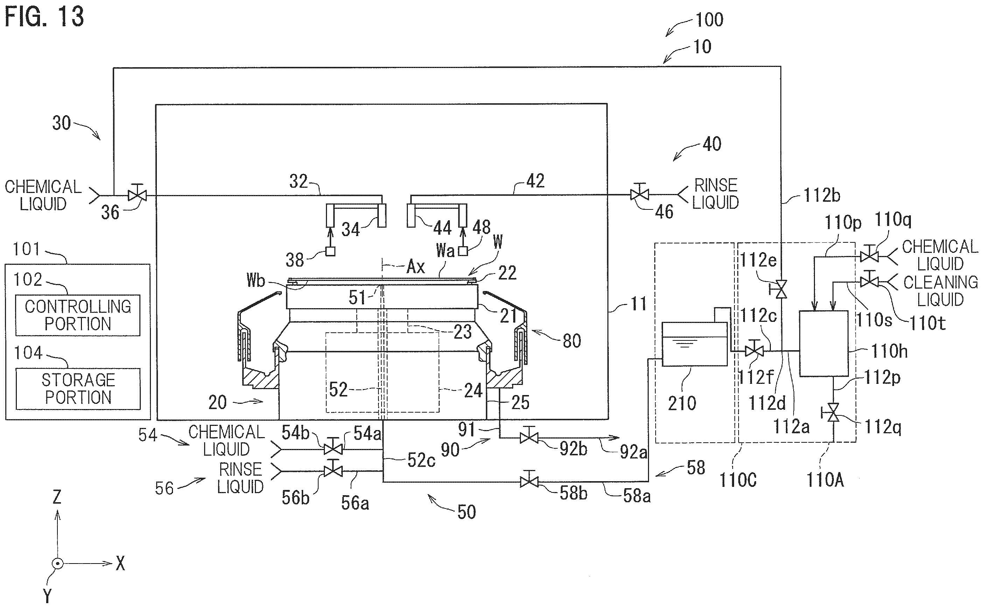

Next, the substrate processing apparatus 100 according to the present preferred embodiment will be described with reference to FIGS. 1 to 13. FIG. 13 is a schematic diagram of the substrate processing apparatus 100 according to the present preferred embodiment. The substrate processing apparatus 100 in FIG. 13 has the same configuration as the substrate processing apparatus 100 illustrated in FIG. 2 except that a cleaning liquid from the chemical liquid cabinet 110A is supplied as the recovered liquid to the recovered-liquid storage tank 210, and redundant description is omitted in order to avoid the lengthy description.

As illustrated in FIG. 13, in the substrate processing apparatus 100, a chemical liquid and a cleaning liquid are supplied to the chemical liquid cabinet 110A. For example, the chemical liquid cabinet 110A prepares a chemical liquid. The chemical liquid cabinet 110A supplies the chemical liquid to the processing liquid box 120. In FIG. 13, the chemical liquid cabinet 110A is disposed adjacent to the recovered-liquid cabinet 110C.

The chemical liquid cabinet 110A is cleaned periodically or as necessary. In the case of cleaning the chemical liquid cabinet 110A, a cleaning liquid is supplied to the chemical liquid cabinet 110A.

The cleaning liquid may contain any one of, for example, deionized water (DIW), carbonated water, electrolyzed ion water, ozone water, ammonia water, hydrochloric acid solution with a diluted concentration (for example, about 10 ppm to 100 ppm), and reduced water (hydrogen water).

Typically, the cleaning liquid supplied to the chemical liquid cabinet 110A is discharged. However, the cleaning liquid supplied to the chemical liquid cabinet 110A may be recovered in the recovered-liquid storage tank 210.

The chemical liquid cabinet 110A includes a chemical liquid storage tank 110h. The chemical liquid storage tank 110h can store the chemical liquid. In a case where the substrate W is processed with the chemical liquid in the substrate processing unit 10, the chemical liquid stored in the chemical liquid storage tank 110h is supplied to the substrate processing unit 10. For example, the chemical liquid stored in the chemical liquid storage tank 110h may be supplied to process the front surface Wa of the substrate W. Alternatively, the chemical liquid stored in the chemical liquid storage tank 110h may be supplied to process the rear surface Wb of the substrate W.

The chemical liquid cabinet 110A includes a chemical liquid storage tank 110h, a piping 112a, a piping 112b, a piping 112c, a valve 112e, a valve 112f, a piping 112p, and a valve 112q. The chemical liquid storage tank 110h stores a chemical liquid.

The chemical liquid is supplied to the chemical liquid storage tank 110h. A chemical liquid having a flow rate which is controlled by a valve 110q is supplied to the chemical liquid storage tank 110h through a piping 110p. The chemical liquid is supplied from the supply source to the piping 110p. The valve 110q opens and closes a flow channel in the piping 110p. The valve 110q adjusts an opening degree of the piping 110p to adjust the flow rate of the chemical liquid flowing in the piping 110p.

The chemical liquid storage tank 110h is cleaned with the cleaning liquid. In the case of cleaning the chemical liquid storage tank 110h, a cleaning liquid is supplied to the chemical liquid storage tank 110h. The cleaning liquid having a flow rate which is controlled by the valve 110t is supplied to the chemical liquid storage tank 110h through a piping 110s. The cleaning liquid is supplied from a supply source to the piping 110s. The valve 110t opens and closes a flow channel in the piping 110s. The valve 110t adjusts an opening degree of the piping 110s to adjust the flow rate of the cleaning liquid supplied to the piping 110s.

The piping 112a connects the chemical liquid storage tank 110h, the piping 112b, and the piping 112c. The piping 112a, the piping 112b, and the piping 112c are connected at a connection point 112d. One end of the piping 112a is connected to the chemical liquid storage tank 110h, and the other end of the piping 112a is connected to the connection point 112d.

The piping 112b connects the substrate processing unit 10 and the connection point 112d through the processing liquid box 120. Therefore, the chemical liquid flowing in the piping 112b is used as the processing liquid of the substrate processing unit 10. The valve 112e is attached to the piping 112b. The valve 112e adjusts an opening degree of the piping 112b to adjust a flow rate of the chemical liquid flowing in the piping 112b.

It is noted that, before the chemical liquid storage tank 110h is cleaned, the chemical liquid is discharged from the chemical liquid storage tank 110h. The piping 112p is connected to the chemical liquid storage tank 110h. The chemical liquid discharged from the chemical liquid storage tank 110h flows in the piping 112p. The valve 112q is attached to the piping 112p. The valve 112q adjusts an opening degree of the piping 112p to adjust a flow rate of the chemical liquid flowing in the piping 112p.

It is noted that, in the case of cleaning the chemical liquid storage tank 110h, the cleaning liquid is supplied to the chemical liquid storage tank 110h. The cleaning liquid supplied to the chemical liquid storage tank 110h flows and is discharged through the piping 112p. The valve 112q adjusts an opening degree of the piping 112p to adjust a flow rate of the cleaning liquid flowing in the piping 112p.

The piping 112c connects the recovered-liquid storage tank 210 and the connection point 112d. The cleaning liquid flowing in the piping 112c is recovered in the recovered-liquid storage tank 210. The valve 112f is attached to the piping 112c. The valve 112f adjusts an opening degree of the piping 112c to adjust a flow rate of the cleaning liquid flowing in the piping 112c.

Before the chemical liquid storage tank 110h is cleaned, the controlling portion 102 opens the valve 112q and closes the valves 112e and 112f, thereby discharging the chemical liquid stored in the chemical liquid storage tank 110h through the piping 112c. Thereafter, the controlling portion 102 opens the valve 112q and maintains the closed state of the valves 112e and 112f, thereby supplying the cleaning liquid to the chemical liquid storage tank 110h and cleaning the chemical liquid storage tank 110h.

Thereafter, the controlling portion 102 opens the valve 112f and closes the valves 112e and 112q, thereby recovering, in the recovered-liquid storage tank 210, the cleaning liquid supplied to the chemical liquid storage tank 110h through the piping 112a and 112c.

As described above, in the recovered-liquid storage tank 210, at least a part of the cleaning liquid for cleaning the chemical liquid storage tank 110h is recovered as the recovered liquid. As described above, the recovered liquid recovered in the recovered-liquid storage tank 210 is supplied to the rear surface Wb of the substrate W. Therefore, the substrate processing apparatus 100 according to the present preferred embodiment can reduce the use amount of a new processing liquid.

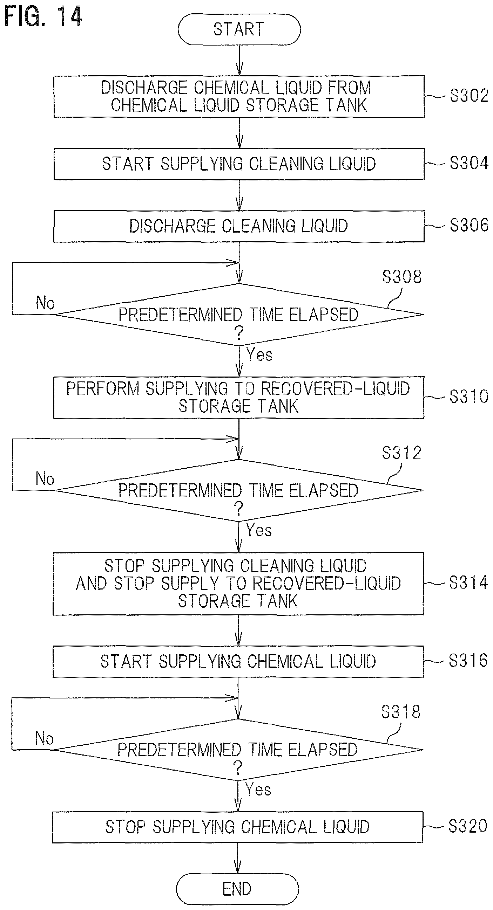

Next, the substrate processing apparatus 100 according to the present preferred embodiment will be described with reference to FIGS. 1 to 14. FIG. 14 is a flowchart of the substrate processing method according to the present preferred embodiment.

As illustrated in FIG. 14, in step S302, the chemical liquid is discharged from the chemical liquid storage tank 110h. The controlling portion 102 opens the valve 112q, thereby discharging the chemical liquid stored in the chemical liquid storage tank 110h through the piping 112p.

In step S304, the cleaning liquid is supplied to the chemical liquid storage tank 110h. The controlling portion 102 closes the valve 112q and opens the valve 110t, thereby supplying the cleaning liquid to the chemical liquid storage tank 110h.

In step S306, the cleaning liquid supplied to the chemical liquid storage tank 110h is discharged. The controlling portion 102 opens the valve 112q while maintaining the open state of the valve 110t, thereby discharging the cleaning liquid supplied to the chemical liquid storage tank 110h.

In step S308, it is determined whether or not a predetermined time has elapsed after the start of the supply of the cleaning liquid or the discharge of the cleaning liquid. The controlling portion 102 measures an elapsed time after the start of the supply of the cleaning liquid or the discharge of the cleaning liquid, and determines whether or not the elapsed time exceeds a threshold value.

In a case where the predetermined time has not elapsed (No in step S308), the process proceeds to step S308 again, and this determination is repeatedly performed until the predetermined time elapses. On the other hand, in a case where it is determined that the predetermined time has elapsed (Yes in step S308), the process proceeds to step S310.

In step S310, the cleaning liquid supplied to the chemical liquid storage tank 110h is caused to flow into the recovered-liquid storage tank 210. The controlling portion 102 closes the valve 112q and opens the valve 112f, thereby recovering, into the recovered-liquid storage tank 210, the cleaning liquid supplied to the chemical liquid storage tank 110h as a recovered liquid.

In step S312, it is determined whether or not a predetermined time has elapsed after the start of the recovery into the recovered-liquid storage tank 210. The controlling portion 102 measures an elapsed time after the start of the recovery into the recovered-liquid storage tank 210, and determines whether or not the elapsed time exceeds a threshold value.

In a case where it is determined that the predetermined time has not elapsed after the start of the recovery into the recovered-liquid storage tank 210 (No in step S312), the process proceeds to step S312 again, and this determination is repeatedly performed until the predetermined time elapses. On the other hand, in a case where it is determined that the predetermined time has elapsed after the start of the recovery into the recovered-liquid storage tank 210 (Yes in step S312), the process proceeds to step S314.

In step S314, the supply of the cleaning liquid to the chemical liquid storage tank 110h is stopped, and the recovery of the cleaning liquid into the recovered-liquid storage tank 210 is stopped. The controlling portion 102 closes the valves 110t and 112f, thereby stopping the recovery of the cleaning liquid supplied to the chemical liquid storage tank 110h as a recovered liquid into the recovered-liquid storage tank 210. Also, the controlling portion 102 opens the valve 112q temporarily and then closes the valve 112q, thereby discharging the cleaning liquid in the chemical liquid storage tank 110h and emptying the chemical liquid storage tank 110h.

In step S316, the supply of the chemical liquid to the chemical liquid storage tank 110h is started. The controlling portion 102 opens the valve 110q and supplies the chemical liquid to the chemical liquid storage tank 110h.

In step S318, it is determined whether or not a predetermined time has elapsed after the start of the supply of the chemical liquid to the chemical liquid storage tank 110h. The controlling portion 102 measures an elapsed time after the start of the supply of the chemical liquid, and determines whether or not the elapsed time exceeds a threshold value.

In a case where the predetermined time has not elapsed after the start of the supply of the chemical liquid (No in step S318), the process proceeds to step S318 again, and this determination is repeatedly performed until the predetermined time elapses. On the other hand, in a case where it is determined that the predetermined time has elapsed after the start of the supply of the chemical liquid (Yes in step S318), the process proceeds to step S320.

In step S320, the supply of the chemical liquid to the chemical liquid storage tank 110h is stopped. The controlling portion 102 closes the valve 110q, thereby stopping the supply of the chemical liquid to the chemical liquid storage tank 110h.

As described above, after the chemical liquid stored in the chemical liquid storage tank 110h is discharged and the chemical liquid storage tank 110h is cleaned with the cleaning liquid, the chemical liquid can be newly stored in the chemical liquid storage tank 110h.

Thereafter, the chemical liquid stored in the chemical liquid storage tank 110h is supplied to the front surface Wa of the substrate W as necessary. The controlling portion 102 opens the valves 110e and 36, thereby supplying, to the front surface Wa of the substrate W, the chemical liquid stored in the chemical liquid storage tank 110h.

According to the present preferred embodiment, the recovered-liquid storage tank 210 recovers, as the recovered liquid, at least a part of the cleaning liquid for cleaning the chemical liquid storage tank 110h. The recovered liquid recovered in the recovered-liquid storage tank 210 is supplied to the rear surface Wb of the substrate W. Therefore, the substrate processing apparatus 100 according to the present preferred embodiment can reduce the use amount of a new processing liquid.

It is noted that, in step S318, the supply of the chemical liquid to the chemical liquid storage tank 110h is controlled based on a period of time during which the valve 110t is opened, but the present preferred embodiment is not limited thereto. The supply of the chemical liquid to the chemical liquid storage tank 110h may be controlled based on a detection result of a sensor in the chemical liquid storage tank 110h.

It is noted that, in the above description with reference to FIGS. 6 to 14, a part of the liquid used in the processing liquid cabinet 110 is recovered in the recovered-liquid storage tank 210, but the present preferred embodiment is not limited thereto. The recovered-liquid storage tank 210 may recover the cleaning liquid used for internal cleaning of the chamber 11.

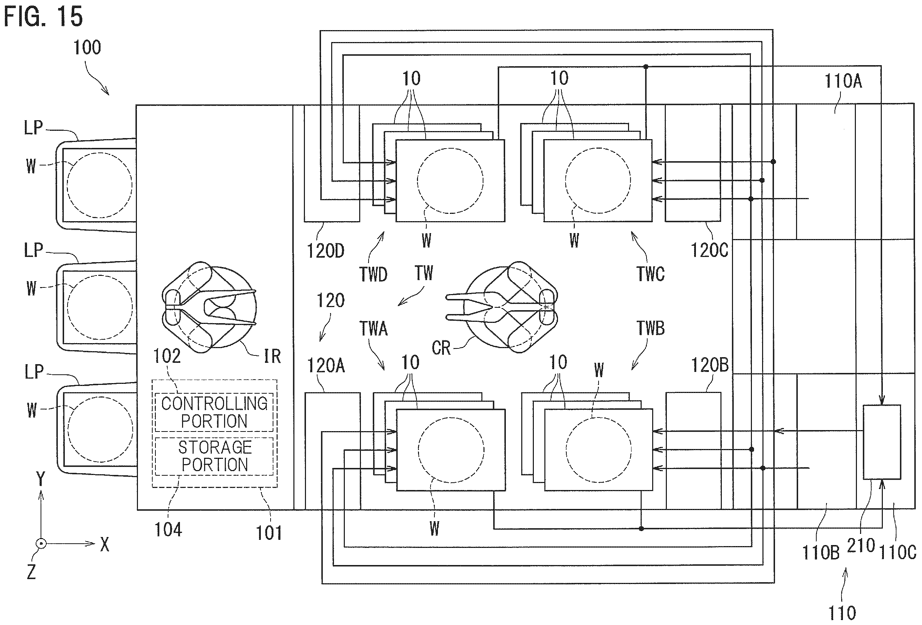

Next, the substrate processing apparatus 100 according to the present preferred embodiment will be described with reference to FIGS. 1 to 15. FIG. 15 is a schematic plan view of the substrate processing apparatus 100 according to the present preferred embodiment. The substrate processing apparatus 100 in FIG. 15 has the same configuration as the substrate processing apparatus 100 illustrated in FIG. 1 except that the liquid flowing from the substrate processing unit 10 is supplied to the recovered-liquid storage tank 210 of the recovered-liquid cabinet 110C, and redundant description is omitted for the purpose of avoiding the lengthy description.

As illustrated in FIG. 15, the recovered-liquid cabinet 110C supplies the recovered liquid to the processing liquid box 120, and the liquid flowing from the substrate processing unit 10 is supplied to the recovered-liquid cabinet 110C. Specifically, the recovered liquid stored in the recovered-liquid storage tank 210 is supplied to the substrate processing unit 10 through the processing liquid box 120. Also, the liquid flowing from the substrate processing unit 10 is recovered as a recovered liquid in the recovered-liquid storage tank 210.

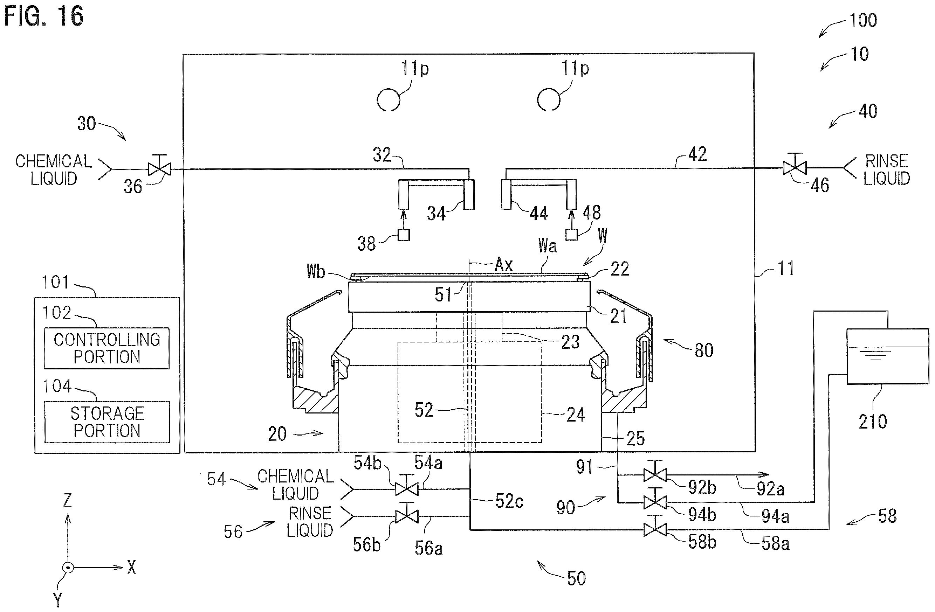

Next, the substrate processing apparatus 100 according to the present preferred embodiment will be described with reference to FIGS. 1 to 16. FIG. 16 is a schematic diagram of the substrate processing apparatus 100 according to the present preferred embodiment. The substrate processing apparatus 100 in FIG. 16 has the same configuration as the substrate processing apparatus 100 illustrated in FIG. 2 except that a piping 11p disposed in the chamber 11 is further provided and the liquid flowing from the substrate processing unit 10 is supplied to the recovered-liquid storage tank 210, and redundant description is omitted in order to avoid the lengthy description.

As illustrated in FIG. 16, in the substrate processing apparatus 100, the piping 11p is disposed in the chamber 11. Here, the piping 11p extends in a Y direction. The piping 11p is positioned above the substrate holding portion 20. The piping 11p has opening portions separated at predetermined intervals. When the cleaning liquid is supplied to the piping 11p, the cleaning liquid is discharged into the chamber 11 from the opening portions of the piping 11p.

Typically, in a case where the substrate holding portion 20 does not hold the substrate W, the cleaning liquid supplied to the piping 11p is discharged into the chamber 11 from the opening portions of the piping 11p. Consequently, the inside of the chamber 11 can be cleaned. In the present specification, the piping 11p is an example of a chamber cleaning piping.

The drain mechanism 90 further includes a piping 94a and a valve 94b in addition to the piping 92a and the valve 92b.

The piping 94a connects the piping 91 and the recovered-liquid storage tank 210. In the piping 94a, the cleaning liquid trapped in the cup 80 flows from the piping 91. The valve 94b opens and closes a flow channel in the piping 94a. The valve 94b adjusts an opening degree of the piping 94a to adjust a flow rate of the cleaning liquid flowing in the piping 94a. The valve 94b may have a configuration similar to that of the valve 92b.

In a case where the valve 94b is opened, the cleaning liquid trapped in the cup 80 flows in the piping 94a to the recovered-liquid storage tank 210. In the present specification, the piping 91 and the piping 94a which connect the cup 80 and the recovered-liquid storage tank 210 are an example of a drain piping.

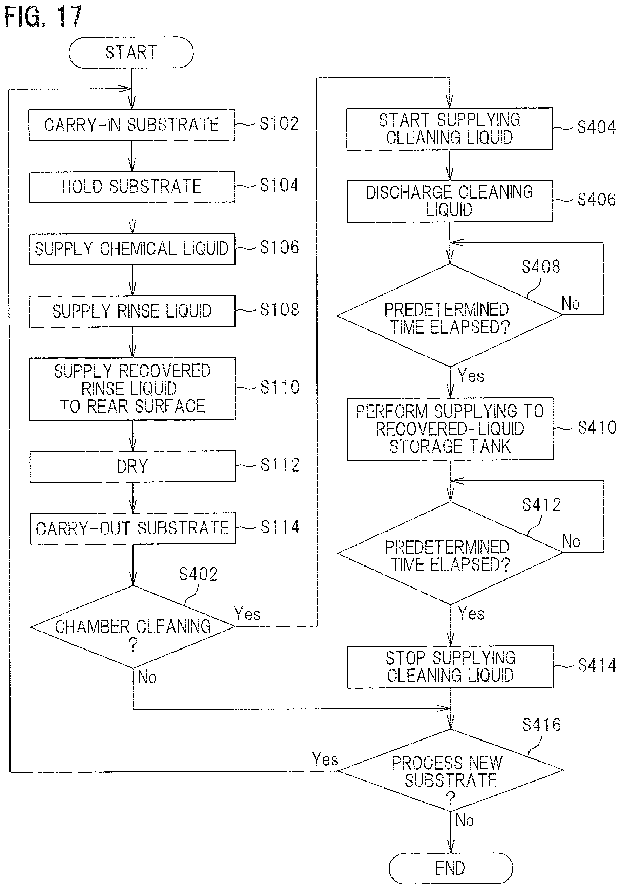

Next, the substrate processing apparatus 100 according to the present preferred embodiment will be described with reference to FIGS. 1 to 17. FIG. 17 is a flowchart of a substrate processing method according to the present preferred embodiment.

In the flowchart of FIG. 17, steps S102 to S114 are similar to steps S102 to S114 described above with reference to FIG. 4, and redundant description is omitted to avoid the lengthy description. After the substrate W is carried out in step S114, the process proceeds to step S402.

In step S402, it is determined whether or not to clean the inside of the chamber 11. For example, the controlling portion 102 determines whether or not to clean the inside of the chamber 11 based on whether or not the number of substrates W processed after the previous chamber cleaning exceeds a threshold value. Alternatively, the controlling portion 102 determines whether or not to clean the inside of the chamber 11 based on whether or not an elapsed time after the previous chamber cleaning exceeds a threshold value. Alternatively, the controlling portion 102 may determine whether to clean the inside of the chamber 11 based on a measurement result of the atmosphere, temperature, or the like in the chamber 11.

In a case where it is determined to clean the inside of the chamber 11 (Yes in step S402), the process proceeds to step S404. On the other hand, in a case where it is determined not to clean the inside of the chamber 11 (No in step S402), the process proceeds to step S416.

In step S404, the cleaning liquid is supplied to the chamber 11. Consequently, the inside of the chamber 11 is cleaned. The controlling portion 102 supplies the cleaning liquid to the piping 11p in the chamber 11 to clean the inside of the chamber 11. The process proceeds to step S406.

In step S406, the cleaning liquid supplied to the chamber 11 is discharged. For example, the controlling portion 102 closes the valve 94b and opens the valve 92b, thereby discharging the cleaning liquid used for cleaning the chamber 11 through the pipings 91 and 92a. The process proceeds to step S408.

In step S408, it is determined whether or not a predetermined time has elapsed after the start of the supply of the cleaning liquid. For example, the controlling portion 102 measures an elapsed time after the start of the supply of the cleaning liquid, and determines whether or not the elapsed time is equal to or longer than a threshold value.

In a case where it is determined that the predetermined time has not elapsed (No in step S408), the process proceeds to step S408 again, and this determination is repeatedly performed until the predetermined time elapses. On the other hand, in a case where it is determined that the predetermined time has elapsed (Yes in step S408), the process proceeds to step S410.

In step S410, the cleaning liquid supplied to the chamber 11 is recovered in the recovered-liquid storage tank 210. For example, the controlling portion 102 closes the valve 92b and opens the valve 94b, thereby recovering the cleaning liquid used for cleaning the chamber 11 into the recovered-liquid storage tank 210 through the pipings 91 and 94a. Thereafter, the process proceeds to step S412.

In step S412, it is determined whether or not a predetermined time has elapsed after the start of the recovery of the cleaning liquid. For example, the controlling portion 102 measures an elapsed time after the start of the recovery of the cleaning liquid, and determines whether or not the elapsed time is equal to or longer than a threshold value.

In a case where it is determined that the predetermined time has not elapsed (No in step S412), the process proceeds to step S412 again, and this determination is repeatedly performed until the predetermined time elapses. On the other hand, in a case where it is determined that the predetermined time has elapsed (Yes in step S412), the process proceeds to step S414.

In step S414, the supply of the cleaning liquid is stopped. The controlling portion 102 stops the supply of the cleaning liquid to the piping 11p in the chamber 11 and ends the cleaning of the inside of the chamber 11. Also, the controlling portion 102 closes the valve 94b. The process proceeds to step S416.

In step S416, it is determined whether or not to process a new substrate W. For example, the controlling portion 102 does not end the substrate processing in a case where an instruction for the substrate W to be processed next is received, and ends the substrate processing in a case where the instruction for the substrate W to be processed next is not received.

In a case where it is determined to process the new substrate W (No in step S416), the process returns to step S102 to newly process the substrate W. On the other hand, in a case where it is determined not to process the new substrate W (Yes in step S416), the process ends.

As described above, the recovered-liquid storage tank 210 recovers, as the recovered liquid, at least a part of the cleaning liquid for cleaning the chemical liquid storage tank 110h. As described above, the recovered liquid recovered in the recovered-liquid storage tank 210 is supplied to the rear surface Wb of the substrate W. Hence, according to the present preferred embodiment, the use amount of a new processing liquid can be reduced.

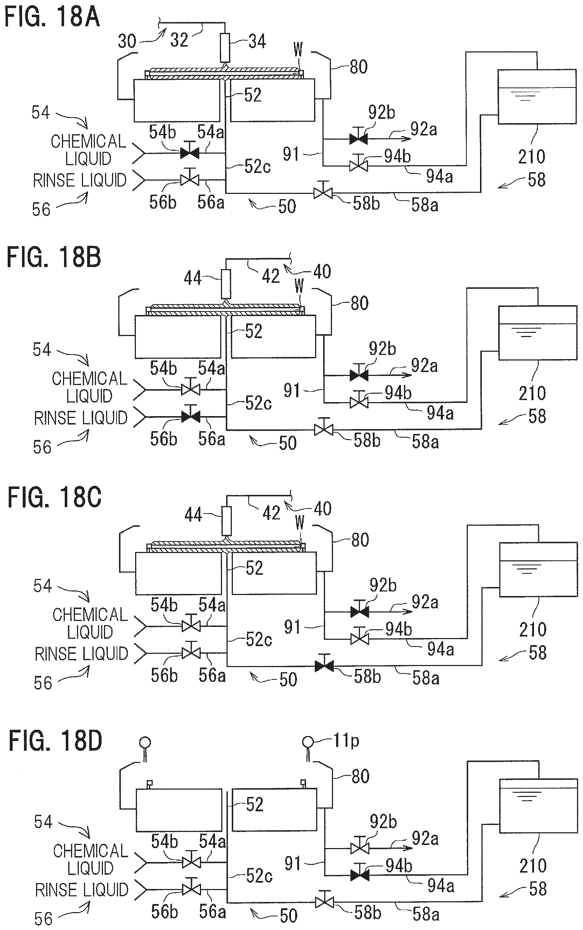

Next, the substrate processing apparatus 100 according to the present preferred embodiment will be described with reference to FIGS. 1 to 18D. FIGS. 18A to 18D are schematic diagrams illustrating a flow of the substrate processing apparatus 100 according to the present preferred embodiment. The diagrams of a flow in FIGS. 18A to 18D are similar to the schematic diagrams of FIGS. 5A to 5C except that FIG. 18D is newly added, and redundant description is omitted in order to avoid the lengthy description.

As illustrated in FIG. 18A, the chemical liquid is supplied to the front surface Wa and the rear surface Wb of the substrate W, and the front surface Wa and the rear surface Wb of the substrate W are processed with the chemical liquid. The chemical liquid supplying portion 30 supplies the chemical liquid to the front surface Wa of the rotating substrate W. The rear surface processing liquid supplying portion 50 supplies the chemical liquid to the rear surface Wb of the rotating substrate W. Here, the cup 80 is positioned at the upper position. Therefore, the cup 80 faces the side portion of the substrate W. The cup 80 traps the chemical liquid scattering in accompaniment with the rotation of the substrate W.

In the drain mechanism 90, the valve 92b is opened and the valve 94b is closed. Therefore, the chemical liquid trapped in the cup 80 flows and is discharged through the piping 91 and the piping 92a.

As illustrated in FIG. 18B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 92b is opened, and the valve 94b remains closed. Therefore, the rinse liquid trapped in the cup 80 flows and is discharged through the piping 91 and the piping 92a.

As illustrated in FIG. 18C, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. For example, the rinse liquid supplying portion 40 continues supplying the rinse liquid to the front surface Wa of the rotating substrate W. The rear surface processing liquid supplying portion 50 supplies the recovered liquid to the rear surface Wb of the rotating substrate W. The cup 80 traps the rinse liquid scattering in accompaniment with the rotation of the substrate W and traps the recovered liquid scattering in accompaniment with the rotation of the substrate W again.

In the drain mechanism 90, the valve 92b is opened, and the valve 94b remains closed. Therefore, the rinse liquid and the recovered liquid trapped in the cup 80 flow and are discharged through the piping 91 and the piping 92a.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

As illustrated in FIG. 18D, the inside of the chamber 11 is cleaned. For example, the cleaning liquid is supplied from the piping 11p into the chamber 11. The cup 80 traps the cleaning liquid.

In the drain mechanism 90, the valve 92b is closed and the valve 94b is opened. Therefore, the cleaning liquid trapped in the cup 80 flows in the piping 91 and the piping 94a and is recovered in the recovered-liquid storage tank 210.

In this manner, the recovered-liquid storage tank 210 recovers, as the recovered liquid, at least a part of the cleaning liquid for cleaning the inside of the chamber 11. The recovered liquid recovered in the recovered-liquid storage tank 210 is supplied to the rear surface Wb of the substrate W. Hence, according to the present preferred embodiment, the use amount of a new processing liquid can be reduced.

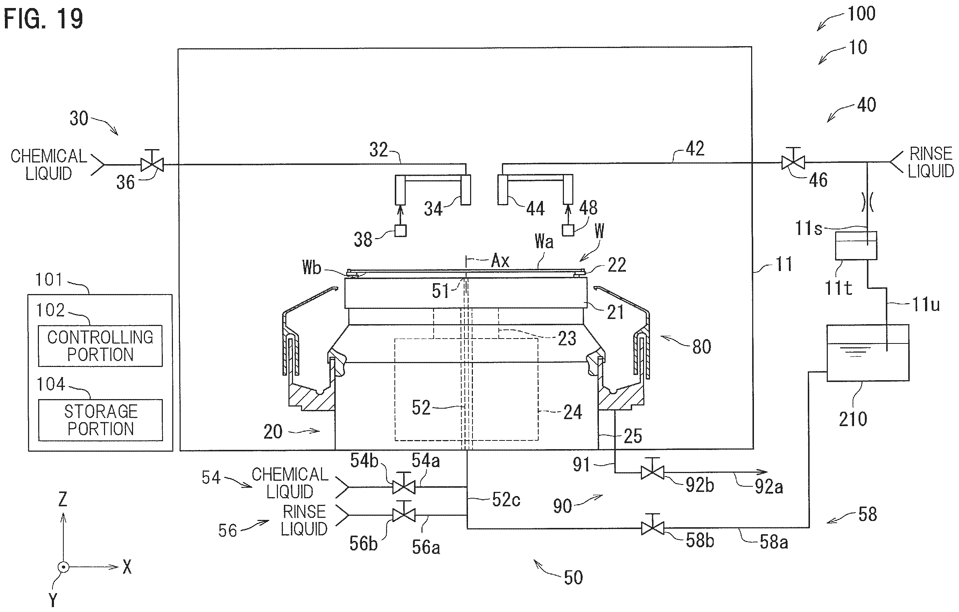

Next, the substrate processing apparatus 100 according to the present preferred embodiment will be described with reference to FIGS. 1 to 19. FIG. 19 is a schematic diagram of the substrate processing apparatus 100 according to the present preferred embodiment. The substrate processing apparatus 100 in FIG. 19 has the same configuration as the substrate processing apparatus 100 illustrated in FIG. 2 except that a rinse liquid storage tank 11t that stores the rinse liquid steadily flowing in a piping 11s connected to the piping 42 of the rinse liquid supplying portion 40 is connected to the recovered-liquid storage tank 210 through a piping 11u, and redundant description is omitted for the purpose of avoiding the lengthy description.

As illustrated in FIG. 19, the substrate processing apparatus 100 further includes the piping 11s, the rinse liquid storage tank 11t, and the piping 11u. The piping 11s connects the piping 42 of the rinse liquid supplying portion 40 and the rinse liquid storage tank 11t. The piping 11s is connected to the piping 42 at a more upstream position than the valve 46. The rinse liquid storage tank 11t stores the rinse liquid which has flowed through the piping 42 and the piping 11s from the supply source. The rinse liquid storage tank 11t is connected to the recovered-liquid storage tank 210 through the piping 11u. The rinse liquid storage tank 11t may be disposed in the chamber 11. Alternatively, the rinse liquid storage tank 11t may be disposed in the processing liquid cabinet 110 or the processing liquid box 120. In the present specification, the piping 42 is an example of a rinse liquid piping, and the piping 11s is an example of a branch piping.

An inner diameter of at least a part of the piping 11s is smaller than an inner diameter of the piping 42. Therefore, in a case where the valve 46 is opened, a flow rate of the rinse liquid flowing through the piping 42 is higher than a flow rate of the rinse liquid flowing through the piping 11s. However, in a case where the valve 46 is closed, the rinse liquid does not flow through the piping 42, and the rinse liquid flows through the piping 11s. Steady flowing of the rinse liquid in the piping 11s connected to the supply source enables bacteria to be prevented from growing in the piping 42 and the piping 11s connected to the supply source.

Here, the rinse liquid storage tank 11t temporarily stores the rinse liquid, and the rinse liquid stored in the rinse liquid storage tank 11t is recovered in the recovered-liquid storage tank 210, but the present preferred embodiment is not limited thereto. The rinse liquid in the piping connected to the supply source may be directly recovered in the recovered-liquid storage tank 210 in a steady manner at a smaller flow rate.

In this manner, the rinse liquid forming a minute flow in the piping 42 in which the rinse liquid circulates is recovered as the recovered liquid. The recovered liquid recovered in the recovered-liquid storage tank 210 is supplied to the rear surface Wb of the substrate W. Hence, according to the present preferred embodiment, the use amount of a new processing liquid can be reduced.

It is noted that, in the substrate processing apparatus 100 described above, the rear surface processing liquid supplying portion 50 can selectively supply the recovered liquid and the rinse liquid to the rear surface Wb of the substrate W, but the present preferred embodiment is not limited thereto. The rear surface processing liquid supplying portion 50 may supply only the recovered liquid to the rear surface Wb of the substrate W.

For example, in the substrate processing apparatus 100 illustrated in FIG. 2, the rear surface processing liquid supplying portion 50 includes the chemical liquid supplying portion 54, the rinse liquid supplying portion 56, and the recovered-liquid supplying portion 58, and in the substrate processing method described above with reference to FIG. 5, the chemical liquid, the rinse liquid, and the recovered liquid are selectively supplied to the rear surface Wb of the substrate W, but the present preferred embodiment is not limited thereto. The rear surface processing liquid supplying portion 50 does not have to include the chemical liquid supplying portion 54 and the rinse liquid supplying portion 56, while including the recovered-liquid supplying portion 58. In this case, the rear surface Wb of the substrate W may be supplied with the recovered liquid, without being supplied with the chemical liquid and the rinse liquid.

Also, in the above description, in the period in which the rinse liquid supplying portion 40 supplies the rinse liquid to the front surface Wa of the substrate W, the rear surface processing liquid supplying portion 50 supplies the recovered liquid to the rear surface Wb of the substrate W after supplying the rinse liquid thereto, but the present preferred embodiment is not limited thereto. In the period in the rinse liquid supplying portion 40 supplies the rinse liquid to the front surface Wa of the substrate W, the rear surface processing liquid supplying portion 50 may supply the recovered liquid without supplying the rinse liquid to the rear surface Wb of the substrate W. In this case, the rear surface processing liquid supplying portion 50 does not have to include the rinse liquid supplying portion 56.

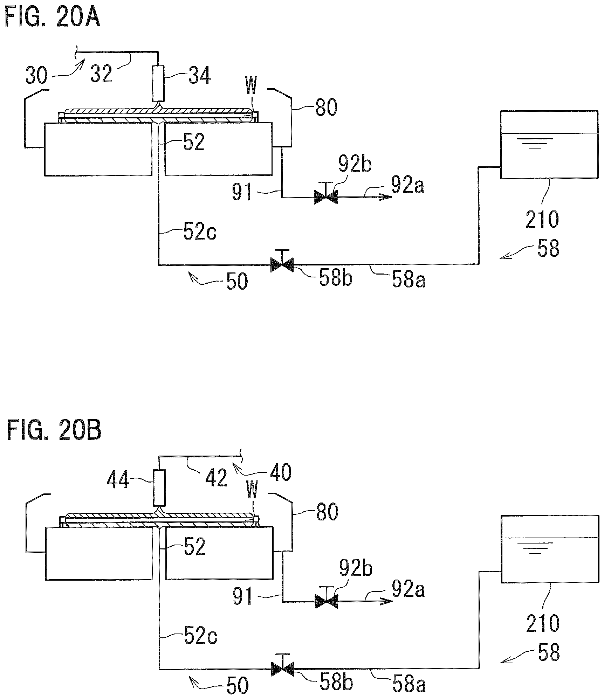

Next, the substrate processing apparatus 100 according to the present preferred embodiment will be described with reference to FIGS. 1 to 20B. FIGS. 20A and 20B are schematic diagrams illustrating a flow of the substrate processing apparatus 100 according to the present preferred embodiment.

As illustrated in FIG. 20A, the chemical liquid is supplied to the front surface Wa of the substrate W so that the front surface Wa of the substrate W is processed with the chemical liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the substrate W.

Here, the cup 80 is positioned at the upper position and faces the side portion of the substrate W. The cup 80 recovers the chemical liquid and the recovered liquid scattering in accompaniment with the rotation of the substrate W.

In the drain mechanism 90, the valve 92b is opened. Therefore, the chemical liquid and the recovered liquid trapped in the cup 80 flow and are discharged through the piping 91 and the piping 92a.

As illustrated in FIG. 20B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W, and the rear surface processing liquid supplying portion 50 supplies the recovered liquid to the rear surface Wb of the rotating substrate W. Here, the cup 80 traps the rinse liquid and the recovered liquid scattering in accompaniment with the rotation of the substrate W again.

In the drain mechanism 90, the valve 92b remains open. Therefore, the rinse liquid and the recovered liquid trapped in the cup 80 flow and are discharged through the piping 91 and the piping 92a.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

In the present preferred embodiment, the front surface Wa of the substrate W is processed with the chemical liquid as described above, and then processed with the rinse liquid. According to the present preferred embodiment, in the period in which the chemical liquid and the rinse liquid are supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in the above description with reference to FIGS. 1 to 19, the rear surface processing liquid supplying portion 50 includes the rinse liquid supplying portion 56 together with the chemical liquid supplying portion 54, but the present preferred embodiment is not limited thereto. The rear surface processing liquid supplying portion 50 may include the chemical liquid supplying portion 54 without including the rinse liquid supplying portion 56.

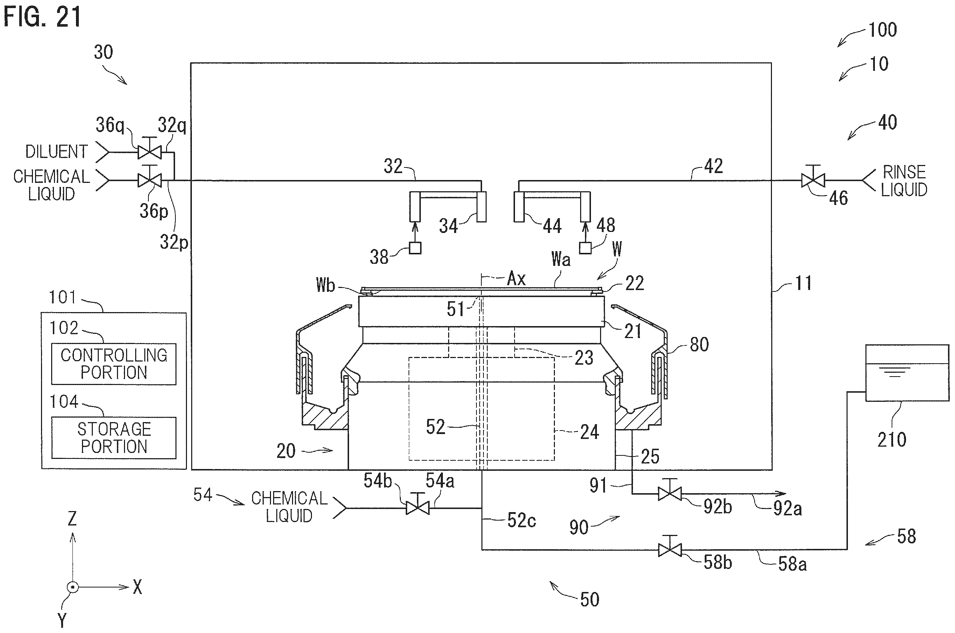

Next, the substrate processing apparatus 100 according to the present preferred embodiment will be described with reference to FIGS. 1 to 21. FIG. 21 is a schematic diagram of the substrate processing apparatus 100 according to the present preferred embodiment. The substrate processing unit 10 in FIG. 21 has the same configuration as the substrate processing apparatus 100 illustrated in FIG. 2 except that a diluted chemical liquid obtained by diluting the chemical liquid with a diluent is supplied to the front surface Wa of the substrate W, and a diluted chemical liquid obtained by diluting the chemical liquid with the recovered liquid is supplied to the rear surface Wb of the substrate W, and redundant description is omitted for the purpose of avoiding the lengthy description.

As illustrated in FIG. 21, in the substrate processing unit 10, the chemical liquid supplying portion 30 supplies the diluted chemical liquid obtained by diluting the chemical liquid with the diluent to the front surface Wa of the substrate W.

The chemical liquid supplying portion 30 includes the piping 32, the nozzle 34, a piping 32p, a valve 36p, a piping 32q, and a valve 36q. The nozzle 34 is connected to one end of the piping 32.

The piping 32p is connected to the other end of the piping 32. The chemical liquid is supplied from the supply source to the piping 32p. The valve 36p opens and closes a flow channel in the piping 32p. When the valve 36p is opened, the chemical liquid flows in the piping 32p.

The chemical liquid contains, for example, hydrofluoric acid. The chemical liquid may contain phosphoric acid. Also, the chemical liquid may contain hydrogen peroxide water. The chemical liquid may contain SC1 (a mixture liquid of ammonia and hydrogen peroxide water), SC2 (a mixture liquid of hydrochloric acid and hydrogen peroxide water), or aqua regia (a mixture of concentrated hydrochloric acid and concentrated nitric acid).

The piping 32q is connected to the other end of the piping 32. The diluent is supplied from a supply source to the piping 32q. The valve 36q opens and closes a flow channel in the piping 32q. When the valve 36q is opened, the diluent flows in the piping 32q.

The diluent may contain, for example, any one of, for example, deionized water (DIW), carbonated water, electrolyzed ion water, ozone water, ammonia water, hydrochloric acid solution with a diluted concentration (for example, about 10 ppm to 100 ppm), or reduced water (hydrogen water). It is noted that, the diluent may be of the same type as the rinse liquid.

When the valve 36p and the valve 36q are opened, the chemical liquid and the diluent flow in the piping 32p and the piping 32q, respectively, whereby the diluted chemical liquid obtained by diluting the chemical liquid with the diluent flow in the piping 32. The nozzle 34 discharges the diluted chemical liquid onto the front surface Wa of the substrate W.

The rear surface processing liquid supplying portion 50 supplies only the recovered liquid or a mixture of the chemical liquid and the recovered liquid to the rear surface Wb of the substrate W. The rear surface processing liquid supplying portion 50 includes the chemical liquid supplying portion 54 and the recovered-liquid supplying portion 58. On the other hand, the substrate processing apparatus 100 illustrated in FIG. 21 differs from the substrate processing apparatus 100 illustrated in FIG. 2 in that the rear surface processing liquid supplying portion 50 does not include the rinse liquid supplying portion 56.

For example, the rear surface processing liquid supplying portion 50 may supply the recovered liquid to the rear surface Wb of the substrate W. Also, the rear surface processing liquid supplying portion 50 may mix the chemical liquid and the recovered liquid and supply the mixture to the rear surface Wb of the substrate W.

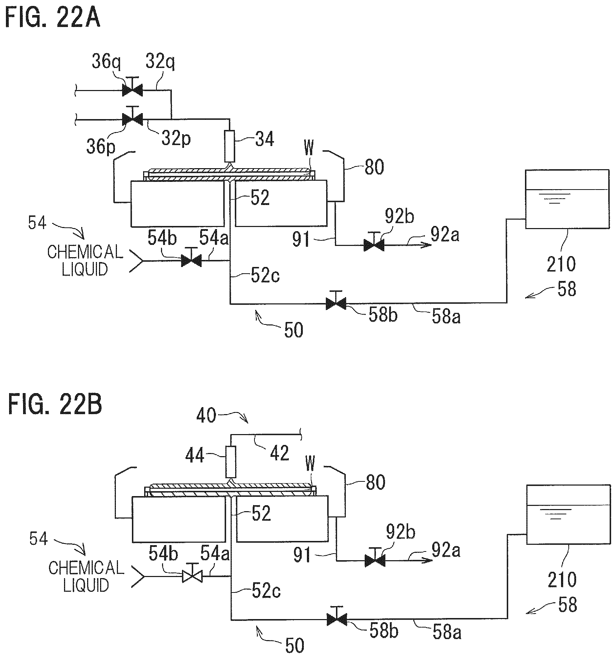

Next, the substrate processing apparatus 100 according to the present preferred embodiment will be described with reference to FIGS. 1 to 22B. FIGS. 22A and 22B are schematic diagrams illustrating a flow of the substrate processing apparatus 100 according to the present preferred embodiment. The flow illustrated in FIGS. 22A and 22B is similar to the flow of the substrate processing apparatus 100 illustrated in FIGS. 5A to 5C except that the substrate W is processed with a diluted chemical liquid, and redundant description is omitted in order to avoid the lengthy description.

As illustrated in FIG. 22A, the diluted chemical liquid is supplied to the front surface Wa and the rear surface Wb of the substrate W, and the front surface Wa and the rear surface Wb of the substrate W are processed with the diluted chemical liquid. The chemical liquid supplying portion 30 supplies the diluted chemical liquid to the front surface Wa of the rotating substrate W. Here, the valve 36p and the valve 36q are open, and the nozzle 34 discharges the diluted chemical liquid to the front surface Wa of the substrate W.

The rear surface processing liquid supplying portion 50 supplies the diluted chemical liquid to the rear surface Wb of the rotating substrate W. The valve 54b and the valve 58b are open. Therefore, the chemical liquid flowing in the piping 54a and the recovered liquid flowing in the piping 58a are mixed in the piping 52c to generate a diluted chemical liquid. Thereafter, the nozzle 51 discharges the diluted chemical liquid to the rear surface Wb of the substrate W.

Here, the cup 80 is positioned at the upper position and faces the side portion of the substrate W. In this case, the cup 80 traps the diluted chemical liquid scattering from the substrate W in accompaniment with the rotation of the substrate W.

In the drain mechanism 90, the valve 92b is opened. Therefore, the diluted chemical liquid trapped in the cup 80 flows and is discharged through the piping 91 and the piping 92a.

As illustrated in FIG. 22B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the rotating substrate W. In the rear surface processing liquid supplying portion 50, the valve 54b is closed such that the supply of the chemical liquid is stopped. The cup 80 traps the rinse liquid and the recovered liquid scattering in accompaniment with the rotation of the substrate W.

In the drain mechanism 90, the valve 92b remains open. Therefore, the rinse liquid and the recovered liquid trapped in the cup 80 flow and are discharged through the piping 91 and the piping 92a.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

According to the present preferred embodiment, the front surface Wa of the substrate W is processed with the diluted chemical liquid as described above, and then processed with the rinse liquid. According to the present preferred embodiment, in a period in which the diluted chemical liquid and the rinse liquid are supplied to the front surface Wa of the substrate W, the recovered liquid is supplied to the rear surface Wb of the substrate W as at least a part of the processing liquid. Therefore, the substrate processing apparatus 100 according to the present preferred embodiment can reduce the use amount of a new processing liquid.

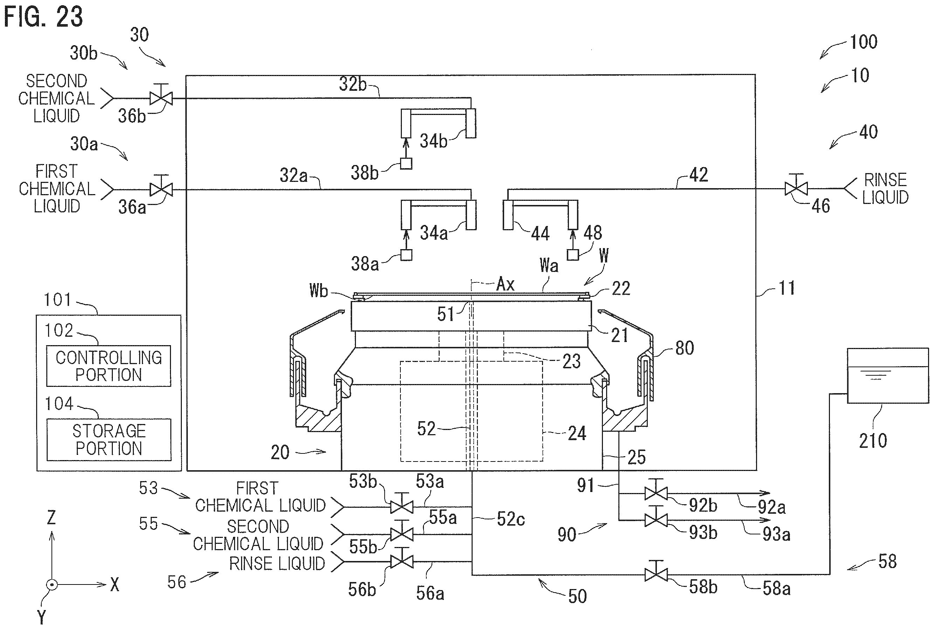

Next, the substrate processing apparatus 100 according to the present preferred embodiment will be described with reference to FIGS. 1 to 23. FIG. 23 is a schematic diagram of the substrate processing apparatus 100 according to the present preferred embodiment. The substrate processing apparatus 100 of FIG. 23 has the same configuration as the substrate processing apparatus 100 illustrated in FIG. 2 except that a first chemical liquid and a second chemical liquid are supplied to the substrate W, and redundant description is omitted for the purpose of avoiding the lengthy description.

As illustrated in FIG. 23, the chemical liquid supplying portion 30 includes a first chemical liquid supplying portion 30a and a second chemical liquid supplying portion 30b. The first chemical liquid supplying portion 30a supplies the first chemical liquid to the front surface Wa of the substrate W. The second chemical liquid supplying portion 30b supplies the second chemical liquid different from the first chemical liquid to the front surface Wa of the substrate W. For example, the first chemical liquid supplying portion 30a supplies hydrofluoric acid to the front surface Wa of the substrate W, and the second chemical liquid supplying portion 30b supplies a mixture liquid of ammonia and hydrogen peroxide water (SC1) to the front surface Wa of the substrate W.

The first chemical liquid supplying portion 30a includes a piping 32a, a nozzle 34a, and a valve 36a. The nozzle 34a is connected to the piping 32a. The first chemical liquid is supplied from a supply source to the piping 32a. The valve 36a opens and closes a flow channel in the piping 32a. The nozzle 34a discharges the first chemical liquid to the front surface Wa of the substrate W.

The valve 36a adjusts an opening degree of the piping 32a to adjust a flow rate of the first chemical liquid supplied to the piping 32a. Specifically, the valve 36a includes a valve body (not shown) with a valve seat provided in an interior, a valve element which opens/closes the valve seat, and an actuator (not shown) which moves the valve element between an open position and a closed position.

The nozzle 34a may be movable. The first chemical liquid supplying portion 30a may further include a nozzle moving portion 38a. The nozzle moving portion 38a may elevate and lower the nozzle 34a, and may horizontally rotate the nozzle 34a around a rotation axis. The nozzle moving portion 38a elevates and lowers the nozzle 34a. For example, the nozzle moving portion 38a includes a ball screw mechanism and an electric motor that applies a driving force to the ball screw mechanism. Also, the nozzle moving portion 38a horizontally rotates the nozzle 34. For example, the nozzle moving portion 38a includes an electric motor.

The second chemical liquid supplying portion 30b includes a piping 32b, a nozzle 34b, and a valve 36b. The nozzle 34b is connected to the piping 32b. The second chemical liquid is supplied from a supply source to the piping 32b. The valve 36b opens and closes a flow channel in the piping 32b. The nozzle 34b discharges the second chemical liquid to the front surface Wa of the substrate W. The piping 32b, the nozzle 34b, the valve 36b, and a nozzle moving portion 38b in the second chemical liquid supplying portion 30b have the same configurations as the piping 32a, the nozzle 34a, the valve 36a, and the nozzle moving portion 38a in the first chemical liquid supplying portion 30a, and redundant description will be omitted.

The rear surface processing liquid supplying portion 50 includes a first chemical liquid supplying portion 53 and a second chemical liquid supplying portion 55. The first chemical liquid supplying portion 53 supplies the first chemical liquid to the rear surface Wb of the substrate W. The second chemical liquid supplying portion 55 supplies the second chemical liquid different from the first chemical liquid to the rear surface Wb of the substrate W. For example, the first chemical liquid supplying portion 53 supplies hydrofluoric acid to the rear surface Wb of the substrate W, and the second chemical liquid supplying portion 55 supplies SC1 (a mixture liquid of ammonia and hydrogen peroxide water) to the rear surface Wb of the substrate W.

The first chemical liquid supplying portion 53 includes a piping 53a and a valve 53b. The first chemical liquid is supplied from a supply source to the piping 53a. The valve 53b opens and closes a flow channel in the piping 53a.

The valve 53b adjusts an opening degree of the piping 53a to adjust a flow rate of the first chemical liquid supplied to the piping 53a. Specifically, the valve 53b includes a valve body (not shown) with a valve seat provided in an interior, a valve element which opens/closes the valve seat, and an actuator (not shown) which moves the valve element between an open position and a closed position.

The second chemical liquid supplying portion 55 includes a piping 55a and a valve 55b. The second chemical liquid is supplied from the supply source to the piping 55a. The valve 55b opens and closes a flow channel in the piping 55a. The piping 55a and the valve 55b in the second chemical liquid supplying portion 55 have the same configurations as the piping 53a and the valve 53b in the first chemical liquid supplying portion 53, and redundant description will be omitted.

The drain mechanism 90 further includes a piping 93a and a valve 93b in addition to the piping 92a and the valve 92b. The piping 92a is connected to the piping 91. The first chemical liquid and the rinse liquid trapped in the cup 80 flow from the piping 91 to the piping 92a.

The piping 93a is connected to the piping 91. The second chemical liquid and the rinse liquid trapped in the cup 80 flow from the piping 91 to the piping 93a. The valve 93b opens and closes a flow channel in the piping 93a. The valve 93b adjusts an opening degree of the piping 93a to adjust a flow rate of the second chemical liquid and the rinse liquid flowing in the piping 93a. Specifically, the valve 93b includes a valve body (not shown) with a valve seat provided in an interior, a valve element which opens/closes the valve seat, and an actuator (not shown) which moves the valve element between an open position and a closed position.

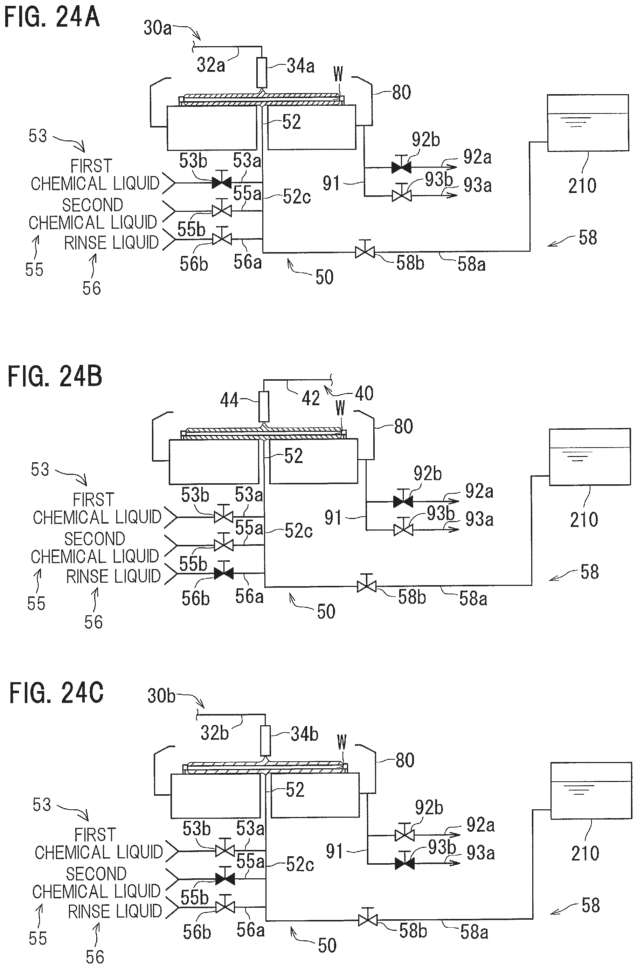

Next, the substrate processing apparatus 100 according to the present preferred embodiment will be described with reference to FIGS. 1 to 25B. FIGS. 24A to 25B are schematic diagrams illustrating a flow of the substrate processing apparatus 100 according to the present preferred embodiment. The flow in FIGS. 24A to 25B is similar to the flow of the substrate processing apparatus 100 illustrated in FIG. 5 except that two types of chemical liquids and the rinse liquid are alternately supplied to the substrate W, and redundant description is omitted for the purpose of avoiding the lengthy description.

As illustrated in FIG. 24A, the first chemical liquid is supplied to the front surface Wa and the rear surface Wb of the substrate W, and the front surface Wa and the rear surface Wb of the substrate W are processed with the first chemical liquid. The first chemical liquid supplying portion 30a supplies the first chemical liquid to the front surface Wa of the rotating substrate W. The rear surface processing liquid supplying portion 50 supplies the first chemical liquid to the rear surface Wb of the rotating substrate W. In this case, the cup 80 traps the first chemical liquid scattering in accompaniment with the rotation of the substrate W.

In the drain mechanism 90, the valve 92b is opened while the valve 93b is closed. Therefore, the first chemical liquid trapped in the cup 80 flows and is discharged through the piping 91 and the piping 92a.

As illustrated in FIG. 24B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 92b is opened, and the valve 93b remains closed. Therefore, the rinse liquid trapped in the cup 80 flows and is discharged through the piping 91 and the piping 92a.

As illustrated in FIG. 24C, the second chemical liquid is supplied to the front surface Wa and the rear surface Wb of the substrate W, and the front surface Wa and the rear surface Wb of the substrate W are processed with the second chemical liquid. The second chemical liquid supplying portion 30b supplies the second chemical liquid to the front surface Wa of the rotating substrate W. The rear surface processing liquid supplying portion 50 supplies the second chemical liquid to the rear surface Wb of the rotating substrate W. The cup 80 traps the second chemical liquid scattering in accompaniment with the rotation of the substrate W.

In the drain mechanism 90, the valve 93b is opened while the valve 92b is closed. Therefore, the second chemical liquid trapped in the cup 80 flows and is discharged through the piping 91 and the piping 93a.

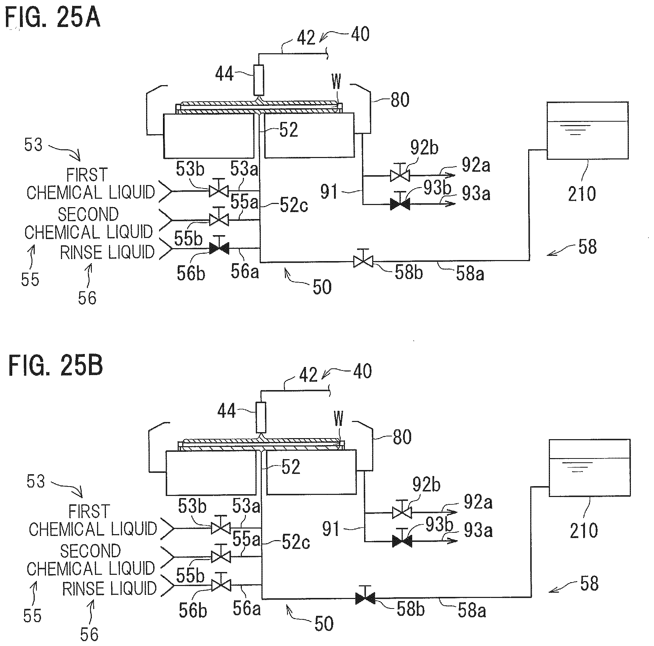

As illustrated in FIG. 25A, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 93b is opened, and the valve 92b remains closed. Therefore, the rinse liquid trapped in the cup 80 flows and is discharged through the piping 91 and the piping 93a.

As illustrated in FIG. 25B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the substrate W. In this case, the cup 80 recovers the rinse liquid and the recovered liquid scattering in accompaniment with the rotation of the substrate W.

In the drain mechanism 90, the valve 93b is opened, and the valve 92b remains closed. Therefore, the rinse liquid and the recovered liquid trapped in the cup 80 flow and are discharged through the piping 91 and the piping 93a.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

According to the present preferred embodiment, the front surface Wa of the substrate W is alternately processed with the first chemical liquid, the second chemical liquid, and the rinse liquid as described above. According to the present preferred embodiment, in the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in the above description with reference to FIGS. 24 to 25B, in the period in which the rinse liquid is supplied to the front surface Wa of the substrate W after the second chemical liquid is supplied thereto, the recovered liquid is supplied to the rear surface Wb of the substrate W after a predetermined time has elapsed, but the present preferred embodiment is not limited thereto. In the period in which the rinse liquid is supplied to the front surface Wa of the substrate W after the first chemical liquid is supplied thereto, the recovered liquid may be supplied to the rear surface Wb of the substrate W after a predetermined time elapses.

Also, in the substrate processing apparatus 100 described above, all of the liquids scattering from the rotating substrate W are trapped in the same cup 80, but the present preferred embodiment is not limited thereto. A plurality of types of cups 80 may be provided.

Also, in the substrate processing apparatus 100 described above, the substrate holding portion 20 increases the rotation speed of the substrate W to dry the substrate W, but the present preferred embodiment is not limited thereto. The substrate W may be dried by supplying a gas. Also, after the substrate W is subjected to the rinse processing, a highly volatile processing liquid may be supplied to the substrate W to dry the substrate W.

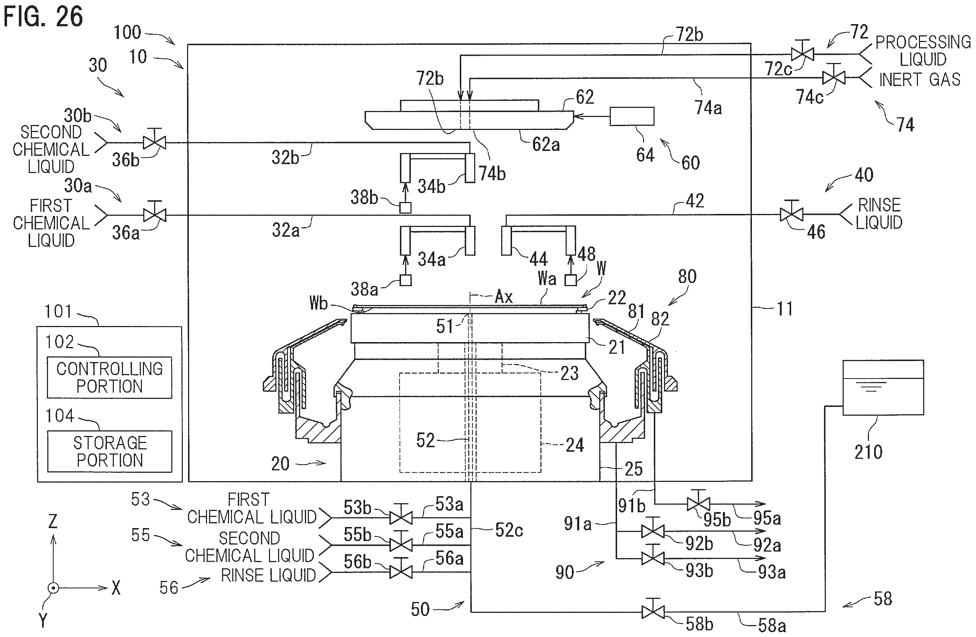

Next, the substrate processing apparatus 100 according to the present preferred embodiment will be described with reference to FIGS. 1 to 26. FIG. 26 is a schematic diagram of the substrate processing apparatus 100 according to the present preferred embodiment. The substrate processing apparatus 100 in FIG. 26 has the same configuration as the substrate processing apparatus 100 illustrated in FIG. 23 except that the cup 80 includes a first cup 81 and a second cup 82, and the substrate processing apparatus 100 further includes a shielding member 60, a processing liquid supplying portion 72, and an inert gas supplying portion 74, and redundant description is omitted for the purpose of avoiding the lengthy description.

As illustrated in FIG. 26, the substrate processing apparatus 100 further includes the shielding member 60, the processing liquid supplying portion 72, and the inert gas supplying portion 74. The shielding member 60 is positioned above the front surface Wa of the substrate W. The shielding member 60 is movable in the vertical direction with respect to the front surface Wa of the substrate W. The shielding member 60 shields the front surface Wa of the substrate W when moving close to the front surface Wa of the substrate W. The shielding member 60 supplies the processing liquid and an inert gas to the front surface Wa of the substrate W.

The shielding member 60 is configured to be movable with respect to the substrate W. The shielding member 60 further includes a shielding plate 62 and a moving portion 64. The shielding plate 62 has a plate shape expanding in a horizontal direction (XY plane). The shielding plate 62 is positioned above the front surface Wa of the substrate W held by the chuck member 22. A lower surface 62a of the shielding plate 62 faces the front surface Wa of the substrate W held by the chuck member 22. The lower surface 62a has, for example, a circular shape. A diameter of the lower surface 62a may be equal to or larger than a diameter of the substrate W.

The moving portion 64 elevates and lowers the shielding plate 62 in the vertical direction. For example, the moving portion 64 includes a ball screw mechanism and an electric motor that applies a driving force to the ball screw mechanism.

The moving portion 64 elevates and lowers the shielding plate 62 between a retreat position and a shielding position. The shielding position is a position lower than the retreat position. Specifically, as compared to the retreat position, the shielding position is a position closer to the substrate W held by the chuck member 22. In FIG. 26, the shielding plate 62 is positioned at the retreat position.

When the shielding plate 62 moves from the retreat position to the shielding position, a processing space is formed by the shielding plate 62 at the shielding position and the cup 80 at the upper position. The processing space is a space substantially shielded from the external atmosphere. That is, the processing space is a local space formed inside the chamber 11. The processing space is substantially shielded from the atmosphere inside the chamber 11.

The processing liquid supplying portion 72 supplies the processing liquid to the front surface Wa of the substrate W. Here, the processing liquid is suitably used for drying the rinse liquid. The processing liquid is preferably a low-surface-tension liquid having the surface tension lower than that of the rinse liquid. In this case, the substrate W is not dried immediately after the rinse liquid on the substrate W is completely spun off, but the substrate W is dried by spinning off the processing liquid on the substrate W after the rinse liquid on the substrate W is replaced with the processing liquid. Therefore, when the processing liquid is the low-surface-tension liquid, it is possible to decrease the surface tension acting on the substrate W when the substrate W is dried.

Examples of organic solvents that function as the processing liquid include a liquid, etc., containing at least one of IPA (isopropyl alcohol), HFE (hydrofluoroether), methanol, ethanol, acetone, PGEE (propylene glycol monoethyl ether), and trans-1,2-dichloroethylene. It is noted that, the processing liquid does not have to be a single component, and may be a liquid mixed with other components. For example, the processing liquid may be a mixed liquid of IPA and DIW or a mixed liquid of IPA and HFE.

The processing liquid supplying portion 72 includes a piping 72a, a nozzle 72b, and a valve 72c. The nozzle 72b is attached to the shielding plate 62. The processing liquid is supplied from a supply source to the piping 72a. The valve 72c opens and closes a flow channel in the piping 72a. The nozzle 72b discharges the processing liquid to the front surface Wa of the substrate W.

The valve 72c adjusts an opening degree of the piping 72a to adjust a flow rate of the processing liquid supplied to the piping 72a. Specifically, the valve 72c includes a valve body (not shown) with a valve seat provided in an interior, a valve element which opens/closes the valve seat, and an actuator (not shown) which moves the valve element between an open position and a closed position.

The inert gas supplying portion 74 supplies an inert gas to the front surface Wa of the substrate W. The inert gas does not substantially change the characteristics of the front surface Wa of the substrate W even when the inert gas is supplied to the front surface Wa of the substrate W. Typically, the inert gas is a nitrogen gas. It is noted that, the inert gas may be a rare gas.

The inert gas supplying portion 74 supplies an inert gas to the front surface Wa of the substrate W. The inert gas supplying portion 74 includes a piping 74a, a nozzle 74b, and a valve 74c. The nozzle 74b is attached to the shielding plate 62. The inert gas is supplied from a supply source to the piping 74a. The valve 74c opens and closes a flow channel in the piping 74a. The nozzle 74b discharges the inert gas to the front surface Wa of the substrate W.

The valve 74c adjusts an opening degree of the piping 74a to adjust a flow rate of the inert gas supplied to the piping 74a. Specifically, the valve 74c includes a valve body (not shown) with a valve seat provided in an interior, a valve element which opens/closes the valve seat, and an actuator (not shown) which moves the valve element between an open position and a closed position.

The nozzle 72b and the nozzle 74b are installed in the shielding plate 62. The discharge ports of the nozzle 72b and the nozzle 74b are open to the lower surface 62a of the shielding plate 62. The discharge ports of the nozzle 72b and the nozzle 74b may be positioned to face the central portion of the substrate W held by the chuck member 22. The nozzle 72b discharges the processing liquid toward the front surface Wa of the substrate W. The nozzle 74b discharges the inert gas toward the front surface Wa of the substrate W.

The cup 80 includes the first cup 81 and the second cup 82. The second cup 82 is positioned on an outer side in a radial direction of the substrate W with respect to the first cup 81. Both the first cup 81 and the second cup 82 are elevated and lowered along the vertical direction. The first cup 81 and the second cup 82 are elevated to an upper position that is positioned laterally to the substrate W. Also, the first cup 81 and the second cup 82 are lowered to a lower position that is positioned obliquely below the substrate W. The first cup 81 and the second cup 82 trap a liquid scattered from the substrate W.

It is noted that, the second cup 82 is positioned above the first cup 81 such as to overlap the first cup 81. Therefore, in a case where the first cup 81 is lowered, the second cup 82 can be lowered to a position where the first cup 81 is lowered.

The drain mechanism 90 discharges the chemical liquid, the rinse liquid, and the processing liquid trapped in the cup 80 to the outside of the chamber 11. The drain mechanism 90 includes a piping 91a to discharge the processing liquid trapped in the first cup 81 and a piping 91b to discharge the processing liquid trapped in the second cup 82. One end of the piping 91a is connected to a bottom portion of the first cup 81. One end of the piping 91b is connected to a bottom portion of the second cup 82.

The drain mechanism 90 further includes a piping 95a and a valve 95b in addition to the piping 92a, the valve 92b, the piping 93a, and the valve 93b. The pipings 92a and 93a are connected to the piping 91a. The piping 95a is connected to the piping 91b. The valve 95b may have a configuration similar to those of the valves 92b and 93b.

For example, the first cup 81 is positioned vertically above and to the lateral side of the substrate W over a period in which the first chemical liquid supplying portion 30a supplies the first chemical liquid to the substrate W. At this time, the second cup 82 is also positioned on the upper side similarly to the first cup 81.

Also, the first cup 81 is positioned laterally to the substrate W over a period in which the rinse liquid supplying portion 40 supplies the rinse liquid to the substrate W. Thereafter, the first cup 81 is positioned laterally to the substrate W over a period in which the second chemical liquid supplying portion 30b and the rinse liquid supplying portion 40 supply the second chemical liquid and the rinse liquid to the substrate W, respectively.

In this case, the first cup 81 traps the first chemical liquid, the rinse liquid, the second chemical liquid, and the rinse liquid scattering in accompaniment with the rotation of the substrate W. Thereafter, when the period in which the rinse liquid supplying portion 40 supplies the rinse liquid to the substrate W ends, the first cup 81 is lowered vertically downward from the lateral side of the substrate W. In this case, the second cup 82 is positioned laterally to the substrate W.

Thereafter, the second cup 82 is positioned laterally to the substrate W over a period in which the shielding member 60 supplies the processing liquid to the substrate W. Thereafter, the second cup 82 is positioned laterally to the substrate W over a period in which the shielding member 60 supplies the inert gas to the substrate W. Thereafter, when the period in which the shielding member 60 supplies the inert gas to the substrate W ends, the second cup 82 is lowered vertically downward from the lateral side of the substrate W.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

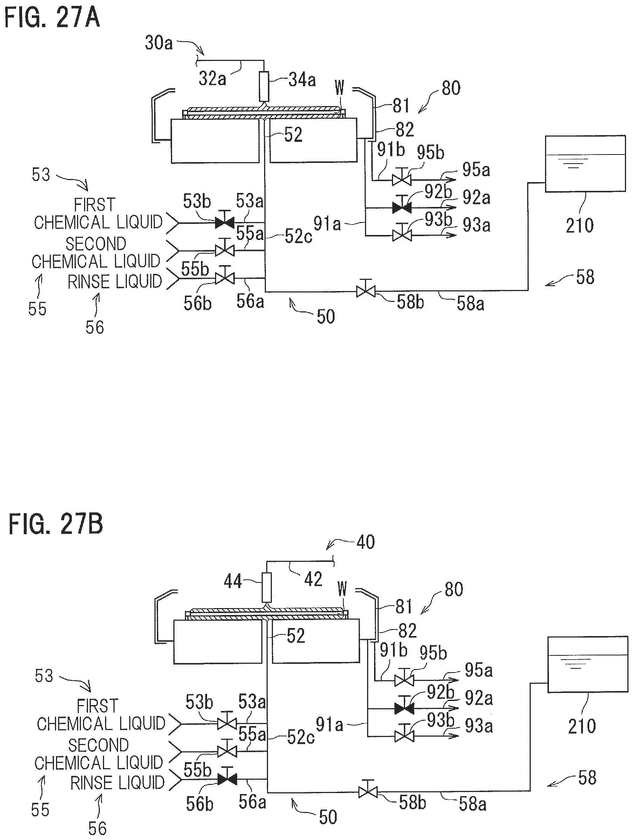

Next, the substrate processing apparatus 100 according to the present preferred embodiment will be described with reference to FIGS. 1 to 30. FIGS. 27A to 30 are schematic diagrams illustrating a flow of the substrate processing apparatus 100 according to the present preferred embodiment. FIGS. 27A to 30 are similar to FIGS. 24A to 25B except that the cup 80 includes the first cup 81 and the second cup 82, and the processing liquid and the inert gas are supplied from the shielding member 60 to the front surface Wa of the substrate W, and redundant description is omitted in order to avoid the lengthy description.

As illustrated in FIG. 27A, the first chemical liquid is supplied to the front surface Wa and the rear surface Wb of the substrate W, and the front surface Wa and the rear surface Wb of the substrate W are processed with the first chemical liquid. The first chemical liquid supplying portion 30a supplies the first chemical liquid to the front surface Wa of the rotating substrate W. The rear surface processing liquid supplying portion 50 supplies the first chemical liquid to the rear surface Wb of the rotating substrate W.

Here, both the first cup 81 and the second cup 82 are positioned at the upper position. Therefore, the first cup 81 faces the side portion of the substrate W, and the first cup 81 traps the first chemical liquid scattering in accompaniment with the rotation of the substrate W.

In the drain mechanism 90, the valve 92b is opened while the valves 93b and 95b are closed. Therefore, the first chemical liquid trapped in the first cup 81 flows and is discharged through the piping 91a and the piping 92a.

As illustrated in FIG. 27B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The first cup 81 traps the rinse liquid scattering in accompaniment with the rotation of the substrate W.

In the drain mechanism 90, the valve 92b is opened, and the valves 93b and 95b remain closed. Therefore, the rinse liquid trapped in the first cup 81 flows and is discharged through the piping 91a and the piping 92a.

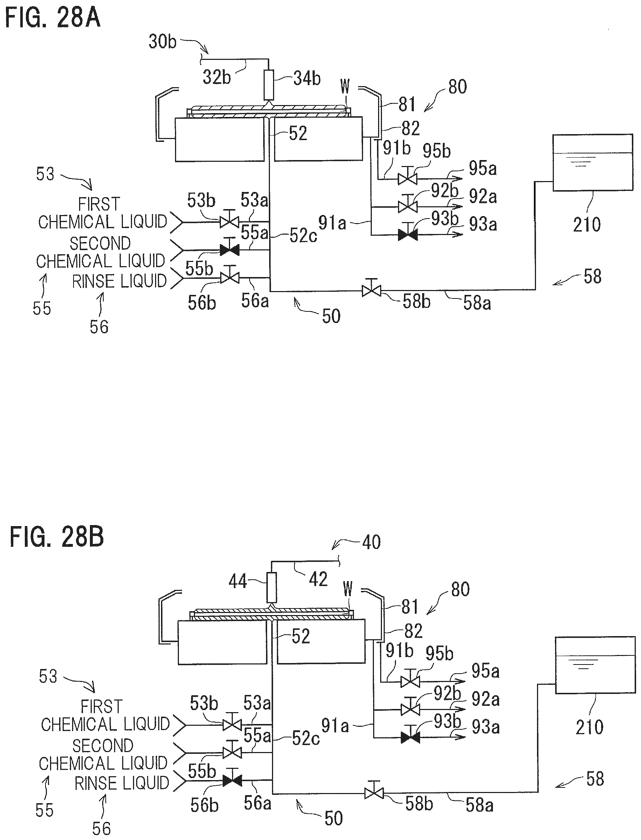

As illustrated in FIG. 28A, the second chemical liquid is supplied to the front surface Wa and the rear surface Wb of the substrate W, and the front surface Wa and the rear surface Wb of the substrate W are processed with the second chemical liquid. The second chemical liquid supplying portion 30b supplies the second chemical liquid to the front surface Wa of the rotating substrate W. The rear surface processing liquid supplying portion 50 supplies the second chemical liquid to the rear surface Wb of the rotating substrate W. Here, the first cup 81 traps the second chemical liquid scattering in accompaniment with the rotation of the substrate W.

In the drain mechanism 90, the valve 93b is opened while the valves 92b and 95b are closed. Therefore, the second chemical liquid trapped in the first cup 81 flows and is discharged through the piping 91a and the piping 93a.

As illustrated in FIG. 28B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. Here, the first cup 81 traps the rinse liquid scattering in accompaniment with the rotation of the substrate W.

In the drain mechanism 90, the valve 93b is opened, and the valves 92b and 95b remain closed. Therefore, the rinse liquid trapped in the first cup 81 flows and is discharged through the piping 91a and the piping 93a.

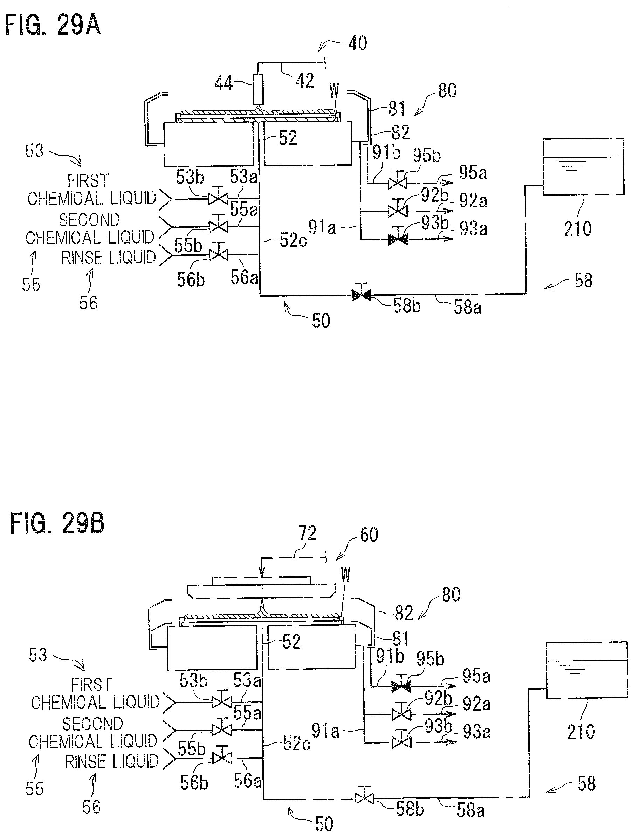

As illustrated in FIG. 29A, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the substrate W.

In the drain mechanism 90, the valve 93b is opened, and the valves 92b and 95b remain closed. Therefore, the rinse liquid and the recovered liquid trapped in the first cup 81 flow and are discharged through the piping 91a and the piping 93a.

As illustrated in FIG. 29B, the processing liquid is supplied to the front surface Wa of the substrate W, and the front surface Wa of the substrate W is processed with the processing liquid. The shielding member 60 supplies the processing liquid to the front surface Wa of the rotating substrate W. The rear surface processing liquid supplying portion 50 stops the supply of the processing liquid to the rear surface Wb of the substrate W.

Here, the first cup 81 moves from the upper position to the lower position, and the second cup 82 is positioned at the upper position. Therefore, the second cup 82 faces the side portion of the substrate W. The second cup 82 traps the processing liquid scattering in accompaniment with the rotation of the substrate W.

In the drain mechanism 90, the valve 95b is opened, and the valves 92b and 93b are closed. Therefore, the processing liquid trapped in the second cup 82 flows and is discharged through the piping 91b and the piping 95a.

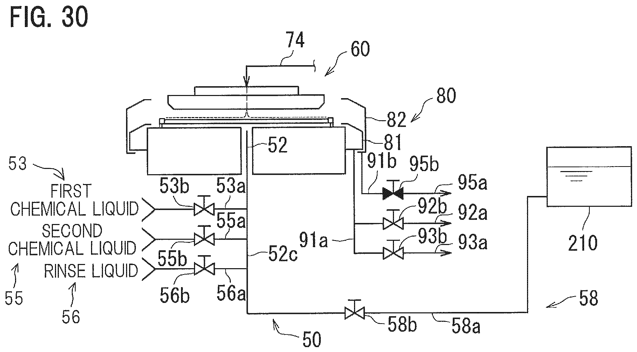

As illustrated in FIG. 30, the inert gas is supplied to the front surface Wa of the substrate W to blow off the processing liquid on the front surface Wa of the substrate W. The shielding member 60 supplies the inert gas to the front surface Wa of the rotating substrate W. The rear surface processing liquid supplying portion 50 remains stopping the supply of the processing liquid to the rear surface Wb of the substrate W. At this time, the substrate holding portion 20 may increase the rotation speed of the substrate W.

Here, the second cup 82 remains positioned at the upper position. The second cup 82 traps the processing liquid scattering in accompaniment with the rotation of the substrate W.

In the drain mechanism 90, the valve 95b is opened, and the valves 92b and 93b remain closed. Therefore, the processing liquid trapped in the second cup 82 flows and is discharged through the piping 91b and the piping 95a.

Thereafter, the shielding member 60 stops the supply of the inert gas, and the substrate holding portion 20 stops the rotation of the substrate W. In this manner, the substrate W is dried. Thereafter, the substrate W is carried out from the chamber 11.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in FIG. 29B, the valve 93b is closed when the shielding member 60 supplies the processing liquid to the front surface Wa of the substrate W, however, when the shielding member 60 supplies the processing liquid to the front surface Wa of the substrate W, the valve 93b in which the rinse liquid and the recovered liquid trapped in the first cup 81 flow may remain open. Consequently, even when the shielding member 60 supplies the processing liquid to the front surface Wa of the substrate W, the rinse liquid and the recovered liquid trapped in the first cup 81 can be discharged. It is noted that, the valve 93b may be opened for a predetermined time from the start of the period in which the shielding member 60 supplies the processing liquid to the front surface Wa of the substrate W, and the valve 93b may be closed after the predetermined time elapses.

It is noted that, in the substrate processing apparatus 100 illustrated in FIGS. 26 to 30, the cup 80 has the first cup 81 and the second cup 82, but the present preferred embodiment is not limited thereto. The cup 80 may include three or more cups.

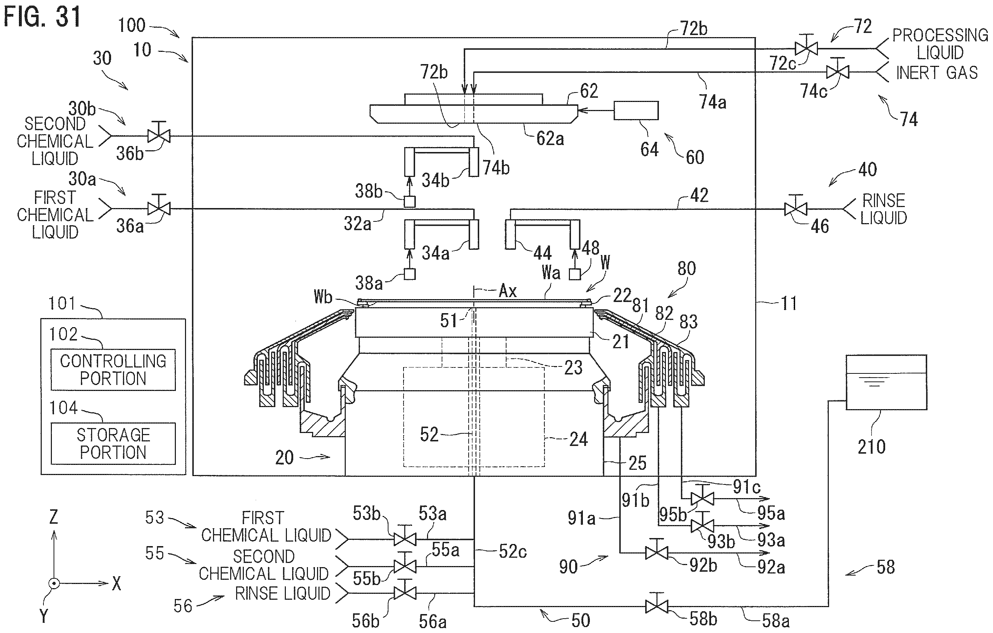

Next, the substrate processing apparatus 100 according to the present preferred embodiment will be described with reference to FIGS. 1 to 31. FIG. 31 is a schematic diagram of the substrate processing apparatus 100 according to the present preferred embodiment. The substrate processing unit 10 in FIG. 31 has the same configuration as the substrate processing apparatus 100 illustrated in FIG. 26 except that the cup 80 further includes a third cup 83 in addition to the first cup 81 and the second cup 82, and redundant description is omitted for the purpose of avoiding the lengthy description.

As illustrated in FIG. 31, the cup 80 includes the first cup 81, the second cup 82, and the third cup 83. The third cup 83 is positioned on an outer side in a radial direction of the substrate W with respect to the second cup 82. The first cup 81 to the third cup 83 are individually elevated and lowered along the vertical direction. The first cup 81 to the third cup 83 are elevated to an upper position that is positioned laterally to the substrate W. Also, the first cup 81 to the third cup 83 are lowered to a lower position that is positioned obliquely below the substrate W. The first cup 81 to the third cup 83 trap a liquid scattered from the substrate W.

It is noted that, the third cup 83 is positioned above the second cup 82 such as to overlap the second cup 82. Therefore, in a case where the second cup 82 is lowered, the third cup 83 can be lowered to a position where the second cup 82 is lowered.

The drain mechanism 90 discharges the chemical liquid, the rinse liquid, and the processing liquid trapped in the cup 80 to the outside of the chamber 11. The drain mechanism 90 includes the piping 91a to discharge the processing liquid trapped in the first cup 81, the piping 91b to discharge the processing liquid trapped in the second cup 82, and a piping 91c to discharge the processing liquid trapped in the third cup 83. One end of the piping 91a is connected to a bottom portion of the first cup 81. One end of the piping 91b is connected to a bottom portion of the second cup 82. One end of the piping 91c is connected to the third cup 83.

In the drain mechanism 90, the piping 92a is connected to the piping 91a. The piping 93a is connected to the piping 91b. The piping 95a is connected to the piping 91c.

For example, the first cup 81 is positioned vertically above and to the lateral side of the substrate W over a period in which the first chemical liquid supplying portion 30a supplies the first chemical liquid to the substrate W. At this time, the second cup 82 is also positioned on the upper side similarly to the first cup 81.

Also, the first cup 81 is positioned laterally to the substrate W over a period in which the rinse liquid supplying portion 40 supplies the rinse liquid to the substrate W. In this case, the first cup 81 traps the first chemical liquid and the rinse liquid scattering in accompaniment with the rotation of the substrate W.

Thereafter, when the period in which the rinse liquid supplying portion 40 supplies the rinse liquid to the substrate W ends, the first cup 81 is lowered vertically downward from the lateral side of the substrate W. In this case, the second cup 82 is positioned laterally to the substrate W.

The second cup 82 is positioned laterally to the substrate W over a period in which the second chemical liquid supplying portion 30b and the rinse liquid supplying portion 40 supply the second chemical liquid and the rinse liquid to the substrate W, respectively. Also, the second cup 82 is positioned laterally to the substrate W while the recovered liquid is supplied to the substrate W. In this case, the second cup 82 traps all of the second chemical liquid, the rinse liquid, and the recovered liquid scattering in accompaniment with the rotation of the substrate W.

Thereafter, when the shielding member 60 shields the front surface Wa of the substrate W and starts supplying the processing liquid to the substrate W, the second cup 82 is lowered vertically downward from the lateral side of the substrate W, and the third cup 83 is positioned laterally to the substrate W in a period in which the shielding member 60 supplies the processing liquid to the substrate W. Thereafter, the third cup 83 is positioned laterally to the substrate W over a period in which the shielding member 60 supplies the inert gas to the substrate W. The third cup 83 traps the processing liquid scattering in accompaniment with the rotation of the substrate W. Thereafter, when the period in which the shielding member 60 supplies the inert gas to the substrate W ends, the third cup 83 is lowered vertically downward from the lateral side of the substrate W.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

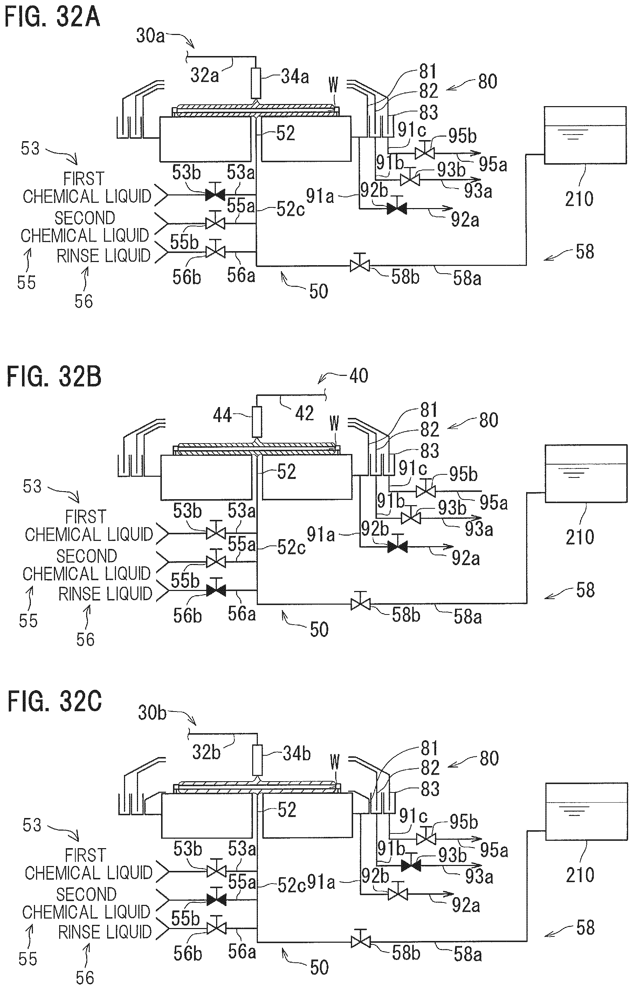

Next, the substrate processing apparatus 100 according to the present preferred embodiment will be described with reference to FIGS. 1 to 34. FIGS. 32A to 34 are schematic diagrams illustrating a flow of the substrate processing apparatus 100 according to the present preferred embodiment. The flow in FIGS. 32A to 34 are similar to the flow of the substrate processing apparatus 100 described above with reference to FIGS. 27A to 30 except that the cup 80 further includes the third cup 83 in addition to the first cup 81 and the second cup 82, and redundant description is omitted in order to avoid the lengthy description.

As illustrated in FIG. 32A, the first chemical liquid is supplied to the front surface Wa and the rear surface Wb of the substrate W, and the front surface Wa and the rear surface Wb of the substrate W are processed with the first chemical liquid. The first chemical liquid supplying portion 30a supplies the first chemical liquid to the front surface Wa of the rotating substrate W. The rear surface processing liquid supplying portion 50 supplies the first chemical liquid to the rear surface Wb of the rotating substrate W.

Here, the first cup 81 to the third cup 83 are all positioned at the upper position. Therefore, the first cup 81 faces the side portion of the substrate W. The first cup 81 traps the first chemical liquid scattering in accompaniment with the rotation of the substrate W.

In the drain mechanism 90, the valve 92b is opened while the valves 93b and 95b are closed. Therefore, the first chemical liquid trapped in the first cup 81 flows and is discharged through the piping 91a and the piping 92a.

As illustrated in FIG. 32B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. Here, the first cup 81 traps the rinse liquid scattering in accompaniment with the rotation of the substrate W.

In the drain mechanism 90, the valve 92b is opened, and the valves 93b and 95b remain closed. Therefore, the rinse liquid trapped in the first cup 81 flows and is discharged through the piping 91a and the piping 92a.

As illustrated in FIG. 32C, the second chemical liquid is supplied to the front surface Wa and the rear surface Wb of the substrate W, and the front surface Wa and the rear surface Wb of the substrate W are processed with the second chemical liquid. The second chemical liquid supplying portion 30b supplies the second chemical liquid to the front surface Wa of the rotating substrate W. The rear surface processing liquid supplying portion 50 supplies the second chemical liquid to the rear surface Wb of the rotating substrate W. Here, the first cup 81 traps the second chemical liquid scattering in accompaniment with the rotation of the substrate W.

Here, the first cup 81 moves from the upper position to the lower position, and the second cup 82 and the third cup 83 are both positioned at the upper position. Therefore, the second cup 82 faces the side portion of the substrate W. The second cup 82 traps the second chemical liquid scattering in accompaniment with the rotation of the substrate W.

In the drain mechanism 90, the valve 93b is opened while the valves 92b and 95b are closed. Therefore, the second chemical liquid trapped in the second cup 82 flows and is discharged through the piping 91b and the piping 93a.

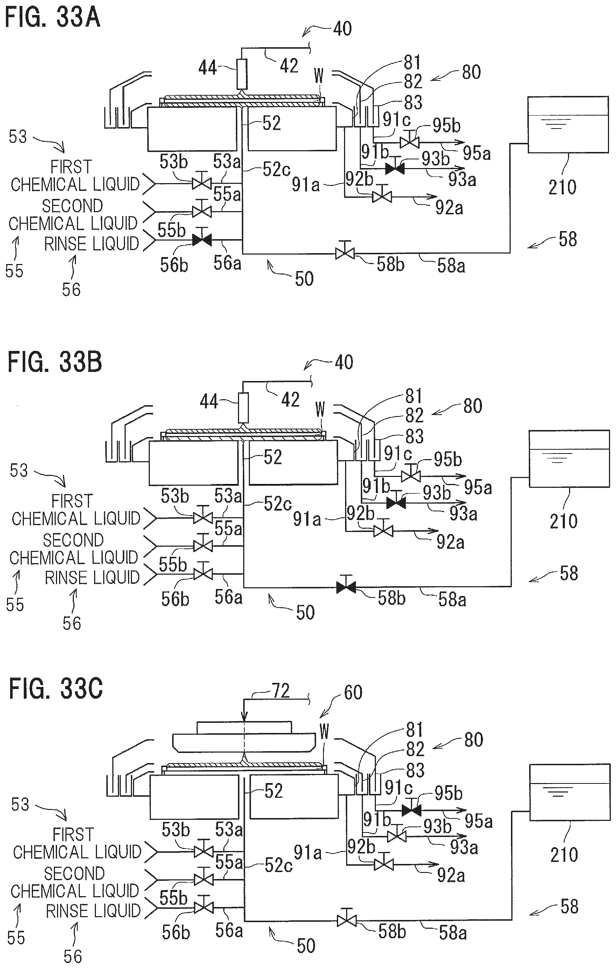

As illustrated in FIG. 33A, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. Here, the second cup 82 traps the rinse liquid scattering in accompaniment with the rotation of the substrate W.

In the drain mechanism 90, the valve 93b is opened, and the valves 92b and 95b remain closed. Therefore, the rinse liquid trapped in the second cup 82 flows and is discharged through the piping 91b and the piping 93a.

As illustrated in FIG. 33B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 continues supplying the rinse liquid to the front surface Wa of the rotating substrate W. The rear surface processing liquid supplying portion 50 supplies the recovered liquid to the rear surface Wb of the substrate W.

In the drain mechanism 90, the valve 93b is opened, and the valves 92b and 95b remain closed. Therefore, the rinse liquid and the recovered liquid trapped in the second cup 82 flow and are discharged through the piping 91b and the piping 93a.

As illustrated in FIG. 33C, the processing liquid is supplied to the front surface Wa of the substrate W, and the front surface Wa of the substrate W is processed with the processing liquid. The shielding member 60 supplies the processing liquid to the front surface Wa of the rotating substrate W. The rear surface processing liquid supplying portion 50 stops the supply of the processing liquid to the rear surface Wb of the substrate W.

Here, the second cup 82 moves from the upper position to the lower position, and third cup 83 is positioned at the upper position. Therefore, the third cup 83 faces the side portion of the substrate W. The third cup 83 traps the processing liquid scattering in accompaniment with the rotation of the substrate W.

In the drain mechanism 90, the valve 95b is opened, and the valves 92b and 93b are closed. Therefore, the processing liquid trapped in the third cup 83 flows and is discharged through the piping 91c and the piping 95a.

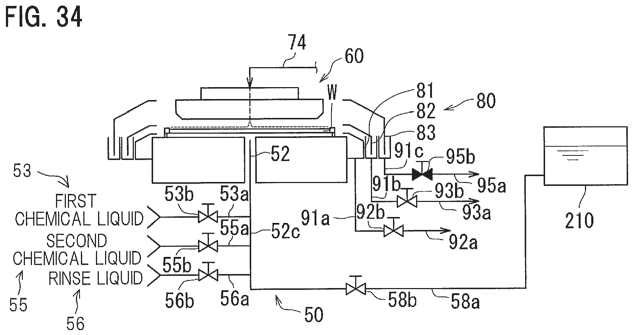

As illustrated in FIG. 34, the inert gas is supplied to the front surface Wa of the substrate W to blow off the processing liquid on the front surface Wa of the substrate W. The shielding member 60 supplies the inert gas to the front surface Wa of the rotating substrate W. The rear surface processing liquid supplying portion 50 remains stopping the supply of the processing liquid to the rear surface Wb of the substrate W. At this time, the substrate holding portion 20 may increase the rotation speed of the substrate W.

Here, the third cup 83 remains positioned at the upper position. The third cup 83 traps the processing liquid scattering in accompaniment with the rotation of the substrate W.

In the drain mechanism 90, the valve 95b is opened, and the valves 92b and 93b remain closed. Therefore, the processing liquid trapped in the third cup 83 flows and is discharged through the piping 91c and the piping 95a.

Thereafter, the shielding member 60 stops the supply of the inert gas, and the substrate holding portion 20 stops the rotation of the substrate W. In this manner, the substrate W is dried. Thereafter, the substrate W is carried out from the chamber 11.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

The preferred embodiments of the present disclosure have been described above with reference to the drawings. However, the present disclosure is not limited to the preferred embodiments described above, and can be implemented in various modes within the range not departing from the gist thereof. Also, by appropriately combining the plurality of constituent elements disclosed in the preferred embodiment described above, it is possible to form various inventions. For example, some constituent elements may be deleted from all constituent elements shown in the preferred embodiment. Further, the constituent elements of different preferred embodiments may be appropriately combined. The drawings schematically show the respective constituent elements mainly in order to facilitate understanding, and the thickness, the length, the number, the interval, etc., of each constituent element shown in the figures may be different from the actual ones for convenience in creating the drawings. Also, the material, the shape, the size, etc., of each constituent element shown in the preferred embodiment described above are not particularly limited but just an example, and can be variously changed within the range substantially not departing from the effects of the present disclosure.

It is noted that, in the substrate processing apparatus 100 described above, the front surface Wa of the substrate W faces vertically upward, and the rear surface Wb of the substrate W faces vertically downward, but the present preferred embodiment is not limited thereto. The front surface Wa of the substrate W may face vertically downward, and the rear surface Wb of the substrate W may face vertically upward. In this case, the recovered liquid is supplied to the rear surface Wb of the substrate W facing vertically upward.

Also, in the substrate processing apparatus 100 illustrated in FIG. 1, the recovered-liquid storage tank 210 is disposed in the processing liquid cabinet 110, but the present preferred embodiment is not limited thereto. The recovered-liquid storage tank 210 may be disposed at a position different from the processing liquid cabinet 110. For example, the recovered-liquid storage tank 210 may be disposed in the processing liquid box 120. Alternatively, the recovered-liquid storage tank 210 may be disposed in the chamber 11.

Although the preferred embodiments of the present invention have been described in detail, these are merely specific examples used to clarify the technical contents of the present invention, and the present invention should not be construed as limited to these specific examples, and the scope of the present invention is limited only by the accompanying claims.

## Claims

1. A substrate processing apparatus (100) comprising:
a chamber (11) to accommodate a substrate (W) having a front surface (Wa) on which a device is provided and a rear surface (Wb) positioned on an opposite side to the front surface (Wa);
a substrate holding portion (20) to hold the substrate (W) in the chamber (11);
a chemical liquid supplying portion (30) to supply a chemical liquid to the front surface (Wa) of the substrate (W) held by the substrate holding portion (20);
a rinse liquid supplying portion (40) to supply a rinse liquid to the front surface (Wa) of the substrate (W) held by the substrate holding portion (20);
a recovered-liquid storage tank (210) to store a recovered liquid obtained by recovering a liquid; and
a rear surface processing liquid supplying portion (50) to supply the recovered liquid stored in the recovered-liquid storage tank (210) to the rear surface (Wb) of the substrate (W) .

2. The substrate processing apparatus (100) according to claim 1, further comprising a controlling portion (102) to determine whether or not to recover the liquid into the recovered-liquid storage tank (210).

3. The substrate processing apparatus (100) according to claim 2, further comprising:
a storage tank (220) to store a liquid;
a heater (224) to heat the liquid flowing from the storage tank (220); and
a temperature measuring portion (225) to measure a temperature of the liquid having heated by the heater (224),
wherein the controlling portion (102) is to determine whether or not to recover a liquid heated by the heater (224) into the recovered-liquid storage tank (210) based on the temperature measured by the temperature measuring portion (225).

4. The substrate processing apparatus (100) according to claim 2 or 3, further comprising:
an ozone gas generator (230s) to generate an ozone gas;
an ozone gas dissolving tank (230t) to dissolve the ozone gas generated in the ozone gas generator (230s) into a liquid to generate an ozone liquid; and
a concentration measuring portion (235) to measure an ozone concentration of the ozone liquid generated in the ozone gas dissolving tank (230t),
wherein the controlling portion (102) is to determine whether or not to recover the ozone liquid generated in the ozone gas dissolving tank (230t) into the recovered-liquid storage tank (210) based on the ozone concentration measured by the concentration measuring portion (235).

5. The substrate processing apparatus (100) according to any one of claims 1 to 4, wherein
the chemical liquid supplying portion (30) includes a chemical liquid storage tank (110h) to store the chemical liquid, and
the recovered-liquid storage tank (210) is to store, as the recovered liquid, at least a part of a cleaning liquid which has cleaned the chemical liquid storage tank (110h).

6. The substrate processing apparatus (100) according to any one of claims 1 to 5, further comprising:
a cup (80) to trap a processing liquid scattering from a substrate (W) held by the substrate holding portion (20);
a drain piping (94a) that connects the cup (80) and the recovered-liquid storage tank (210); and
a chamber cleaning piping (11p) which is disposed in the chamber (11) and through which a cleaning liquid for cleaning an inside of the chamber (11) is to be discharged,
wherein the recovered-liquid storage tank (210) is to store, as the recovered liquid, at least a part of a cleaning liquid discharged from the chamber cleaning piping (11p).

7. The substrate processing apparatus (100) according to any one of claims 1 to 6, wherein
the rinse liquid supplying portion (40) includes
a rinse liquid piping (42) in which the rinse liquid is to flow, and
a valve (46) that is provided in the rinse liquid piping (42) and is to adjust a flow rate of the rinse liquid flowing in the rinse liquid piping (42),
the substrate processing apparatus (100) further comprising
a branch piping (11s) which is connected to the rinse liquid piping (42) at a more upstream position than the valve (46) on the rinse liquid piping (42) and in which the rinse liquid is to flow even in a case where the valve (46) is closed, and
the recovered-liquid storage tank (210) is to store, as the recovered liquid, the rinse liquid which has flowed through the branch piping (11s).

8. A substrate processing method comprising:
a step (S106) of supplying a chemical liquid to a front surface (Wa) of a substrate (W) having the front surface (Wa) on which a device is provided and a rear surface (Wb) positioned on an opposite side to the front surface (Wa);
a step (S108) of supplying a rinse liquid to the front surface (Wa) of the substrate (W) after the chemical liquid is supplied to the front surface (Wa) of the substrate (W); and
a step (S110) of supplying a recovered liquid to the rear surface (Wb) of the substrate (W) from a recovered-liquid storage tank (210) that is to store the recovered liquid obtained by recovering a liquid.

9. The substrate processing method according to claim 8, further comprising a step (S203, S223, S308, S408) of determining whether or not to recover the liquid into the recovered-liquid storage tank (210).

10. The substrate processing method according to claim 9, further comprising:
a step (S201) of heating a liquid flowing from a storage tank (220) to store the liquid; and
a step (S202) of measuring a temperature of the heated liquid,
wherein, in the determination step (S203), whether or not to recover the heated liquid into the recovered-liquid storage tank (210) is determined based on the measured temperature.

11. The substrate processing method according to claim 9 or 10, further comprising:
a step (S221) of dissolving an ozone gas in a liquid to generate an ozone liquid; and
a step (S222) of measuring an ozone concentration of the generated ozone liquid,
wherein, in the determination step (S223), whether or not to recover the generated ozone liquid into the recovered-liquid storage tank (210) is determined based on the measured ozone concentration.

12. The substrate processing method according to any one of claims 8 to 11, further comprising a step (S310) of supplying, as the recovered liquid, at least a part of a cleaning liquid which has cleaned a chemical liquid storage tank (110h) to store the chemical liquid to the recovered-liquid storage tank (210).

13. The substrate processing method according to any one of claims 8 to 12, further comprising:
a step (S404) of discharging a cleaning liquid into a chamber (11), in which the substrate is to be processed, to clean the chamber (11); and
a step (S410) of supplying, as the recovered liquid, at least a part of the cleaning liquid discharged into the chamber (11) to the recovered-liquid storage tank (210).

14. The substrate processing method according to any one of claims 8 to 13, further comprising a step of closing a valve (46) provided in a rinse liquid piping (42) in which the rinse liquid is to flow, causing a rinse liquid to flow to a branch piping (11s) connected to the rinse liquid piping (42) at a more upstream position than the valve (46) on the rinse liquid piping (42), and supplying, as the recovered liquid, the rinse liquid which has flowed through the branch piping (11s) to the recovered-liquid storage tank (210) .
